# FASCICULE DE BREVET EUROPEEN

(11) **EP 3 463 911 B1**
(45) Date de publication et mention de la délivrance du brevet: **29.12.2021**
(21) Numéro de dépôt: 17730395.5
(22) Date de dépôt: 25.05.2017
(51) Int. Cl.: B41J 11/00, B65H 5/04, H05K 3/12, B65G 54/02, B41J 11/06, B65H 5/08, B65H 29/24

(54) **MACHINE D'IMPRESSION SANS CONTACT COMPRENANT UN DISPOSITIF DE MAINTIEN/TRANSPORT DE SUBSTRATS ET SON UTILISATION**
DIGITALDRUCKMASCHINE MIT EINER VORRICHTUNG ZUM HALTEN/ZUFÜHREN VON SUBSTRATEN UND DEREN VERWENDUNG
DIGITAL PRINTING MACHINE WITH A DEVICE FOR RETAINING/CONVEYING SUBSTRATES AND USE THEREOF

(30) Priorité: 27.05.2016 FR 1654810
(43) Date de publication de la demande: 10.04.2019
(73) Titulaire: MGI Digital Technology, 94260 Fresnes (FR); Inkjet Engine Technology, 92190 Meudon (FR)
(72) Inventeur: ABERGEL, Edmond, 75012 Paris (FR); GAUTIER LE BOULCH, Louis, 92190 Meudon (FR)
(74) Mandataire: De Kezel, Eric
(86) Numéro de dépôt international: PCT/EP2017/062712
(87) Numéro de publication internationale: WO 2017/203020

(56) Documents cités:
- EP-A1- 1 008 454
- EP-A1- 2 703 173
- EP-A1- 3 017 957
- EP-A2- 2 351 649
- GB-A- 2 511 819
- JP-A- H09 162 547
- JP-A- 2005 111 856
- JP-A- 2016 040 060
- US-A1- 2002 041 303
- US-B1- 6 230 876

## Description

La présente invention se rapporte au domaine de l'impression, en particulier au domaine de l'impression numérique sans contact avec les substrats, et plus particulièrement à un dispositif permettant de maintenir des substrats imprimables et imprimés lors de leur traitement dans un ensemble de postes de traitement compris dans une machine d'impression, le dit dispositif de maintien des substrats étant réalisé de manière à permettre leur impression dans des conditions optimales. La présente invention permet également de transporter des substrats imprimables et imprimés sur l'ensemble des postes de traitement compris dans une machine d'impression, le transport des substrats étant réalisé de manière à permettre leur impression dans des conditions optimales.

### INTRODUCTION

Le maintien et/ou transport des substrats en utilisant un traitement automatisé ou de fabrication industrielle est un défi technique particulier. Une partie de la difficulté réside dans le maintien/déplacement d'un substrat le long d'une chaine comprenant plusieurs traitements du dit substrat, en particulier pour son maintien lors de deux traitements consécutifs et/ou son déplacement à partir d'un poste de traitement jusqu'au poste de traitement suivant au cours du processus de fabrication/finition du substrat final. Tout dispositif de traitement d'un substrat, et plus particulièrement tout dispositif de traitement par voie numérique d'un substrat, pourra avantageusement bénéficier des avantages de la présente invention. A titre purement illustratif et non limitatif, le dispositif de traitement d'un substrat est sélectionné parmi des dispositifs de découpe laser, de finition, de séchage, de poinçonnage, de découpage, de pliage, et/ou en particulier d'impression, en particulier d'impression numérique à jet d'encre.

Ce défi technique du maintien/transport de substrat est encore plus exacerbé lorsqu'on combine, au sein d'une même machine, différents types d'impression et/ou différents types de séchage. A titre purement illustratif et non limitatif, on citera les impressions d'encres conventionnelles (mono ou polychrome), et/ou de vernis, et/ou l'électronique imprimée, et/ou les séchages comportant par exemple un four de séchage à infrarouge (IR) et/ou à proche-infrarouge (NIR) et/ou à courant d'air chauffé, et/ou un séchage à lampe ultra-violet (UV) et/ou à diode électroluminescente (LED) UV et/ou un procédé photonique. En effet, la combinaison de plusieurs modes d'impressions et de traitements divers au sein d'une même machine requiert un mode de maintien/transport de haute précision (par exemple pour répondre aux exigences de l'électronique imprimée), ainsi qu'un maintien/transport dont les composants n'interfèrent pas avec les exigences d'efficacités de chacun des postes d'impressions et de traitements de manière individuelle et/ou en combinaison ; nous citerons à titre illustratif l'impact négatif que pourrait avoir un poste de traitement sur le poste de traitement qui le suit et/ou sur le poste de traitement qui le précède dans la machine, par exemple le long du chemin de transport (par exemple pour éviter qu'un poste de séchage n'affecte les performances d'un poste d'impression). De plus, la réalisation doit être telle qu'elle permette de maintenir et/ou d'acheminer les substrats de tailles diverses entre tous les postes de traitement de la meilleure manière possible tout en répondant aux exigences liées aux différentes vitesses de chacun des postes de traitements ainsi qu'à des débits de fabrications suffisants pour permettre une application industrielle efficace et rentable.

### ART ANTERIEUR

Il est connu de l'art antérieur, des maintiens/transports de substrats imprimables réalisés par des courroies d'aspiration, qui ont pour fonction de maintenir un substrat contre lesdites courroies en déplacement. Ce type de solution, bien connue de l'homme du métier, présente néanmoins quelques inconvénients. En particulier, ce type de dispositif, occasionnant des mouvements d'air et des gradients de pression, peut provoquer la déformation des substrats si ces derniers sont de taille importante. La précision de l'impression s'en trouvera donc affectée. D'autre part, l'utilisation de ces courroies d'aspiration avec certaines technologies d'impression très répandues, notamment l'impression jet d'encre, peut occasionner une aspiration accidentelle de l'encre présente dans les têtes d'impression et ainsi provoquer le désamorçage des têtes d'impression. Ce genre d'incident nécessite dans le meilleur des cas un réamorçage des têtes, et dans le pire des cas un remplacement des têtes désamorcées, devenues de fait inutilisables.

Pour pallier à ces problèmes, notamment permettre le déplacement de substrats de manière précise, il existe dans l'art antérieur des techniques utilisant des cylindres comportant une pluralité de pinces saisissant les substrats par le bord avant par rapport au sens de déplacement du substrat. Adapté à des machines d'impression de type jet d'encre, ce type de solution présente néanmoins plusieurs inconvénients. En effet, ce système nécessite un arrangement de toutes les têtes jet d'encre de façon orbitale autour d'un cylindre de grande dimension. De plus, ce type de système pose le problème de la difficulté du réglage de la position des têtes d'impression. En effet, pour une impression de qualité, l'encre éjectée des têtes d'impression doit former un jet dont la direction est perpendiculaire à la surface du substrat. On comprend dans ce cas que l'utilisation d'un cylindre pour transporter et tendre le substrat, dont la surface n'est par définition pas plane, impose des réglages fastidieux de la position des têtes d'impression. Pour cette même raison, il est difficile d'utiliser des substrats d'épaisseur variable, le changement de substrat imposant un réglage de toutes les têtes d'impression. D'autre part, le pas d'impression, c'est-à-dire la position des pinces sur le cylindre, est fixe, ce qui signifie que la cadence d'impression reste la même quel que soit la taille du substrat.

Il est également connu de l'art antérieur des systèmes de transport de substrat utilisant des chaines ou convoyeurs sur lesquels sont disposés des pinces pour saisir les substrats et les transporter sur un chemin de transport dont une portion est plane, ce qui résout le problème de l'agencement des têtes d'impression. Cependant, ce type de solution présente toujours le problème d'un pas d'impression fixe, qui impose une cadence fixe et, dans ce cas, pose le problème supplémentaire de ne pas permettre d'utiliser des substrats de différentes tailles sans arrêter l'impression et procéder à un réglage fastidieux de la position des pinces.

Plus récemment, la Demanderesse a proposé dans sa demande de brevet WO2013156540 un dispositif et un procédé permettant de transporter des substrats imprimables de manière précise, adapté à des substrats de divers types, tailles et épaisseurs, et permettant de réaliser des impressions à pas variable. Il y est décrit un système de transport de substrats dans une machine d'impression, le long d'un chemin de transport orienté selon un axe longitudinal depuis au moins un magasin d'entrée fournissant les substrats imprimables, jusqu'à au moins un magasin de sortie recevant les substrats, caractérisé en ce qu'il comprend : des moyens de préhension mobiles, comprenant chacun un système d'ouverture/fermeture assurant la libération ou la préhension d'un substrat, lesdits moyens de préhension comprenant des moyens de préhension avant et arrière, saisissant chacun une partie, respectivement, avant et arrière du substrat le long du chemin de transport, des moyens de guidage pour guider les moyens de préhension le long du chemin de transport, au moins un moyen de motorisation assurant un déplacement des moyens de préhension le long des moyens de guidage, de préférence avec un déplacement indépendant entre au moins les moyens de préhension avant et les moyens de préhension arrière, le système de transport de substrats étant ainsi adapté pour saisir chaque substrat de manière à tendre et déplacer des substrats, même s'ils ont des longueurs variables, le long du chemin de transport, les moyens de guidage, les moyens de préhension et leur système d'ouverture/fermeture associé étant contrôlés par des moyens informatiques.

Bien que le dispositif et le procédé de WO2013156540 répondent déjà de manière très satisfaisante aux besoins de l'homme du métier, la Demanderesse a à présent développé un dispositif et un procédé qui permettent d'améliorer le maintien/transport de substrats imprimables et/ou imprimés sur l'ensemble des postes de traitement compris dans une machine d'impression, en particulier une machine d'impression sans contact avec le substrat, comme les machines d'impression à jet d'encre.

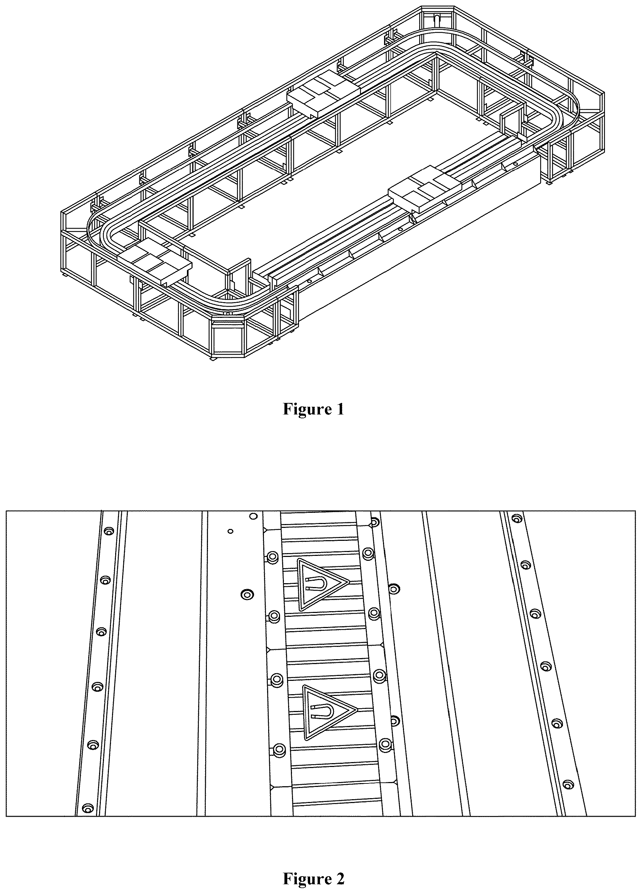

GB2511819 revendique une table pour une imprimante à plat comprenant une plaque supérieure et une plaque inférieure séparées par une couche intermédiaire, la couche intermédiaire étant configurée pour fournir une voie d'écoulement de fluide qui favorise l'écoulement d'un fluide alternant entre une position adjacente à la plaque supérieure et une position adjacente à la plaque inférieure, de manière à favoriser le transfert de chaleur entre la plaque supérieure et la plaque inférieure. La couche intermédiaire comprend une pluralité d'éléments d'espacement formés à partir de parois en tôle de matériau s'étendant entre les plaques ; la voie d'écoulement de fluide est fournie par des trous dans les éléments d'espacement et les trous sont arrangés de manière à être, en alternance, adjacents aux plaques supérieure et inférieure, dans une direction globalement parallèle à la direction d'écoulement, dans lequel, de préférence, les trous sont placés très près, respectivement, du haut ou du bas de la paroi pour faciliter la transfert de chaleur des plaques vers le fluide. De plus, comme représenté dans la figure 1 et décrit dans la description, l'ensemble (plaque supérieure / plaque inférieure / couche intermédiaire) est inamovible car collé, et la plaque supérieure de la table est une matrice de trous d'aspiration comprenant une pluralité d'ouvertures, ce qui est explicitement représentatif d'une sole aspirante traditionnelle percée de multitude de trous.

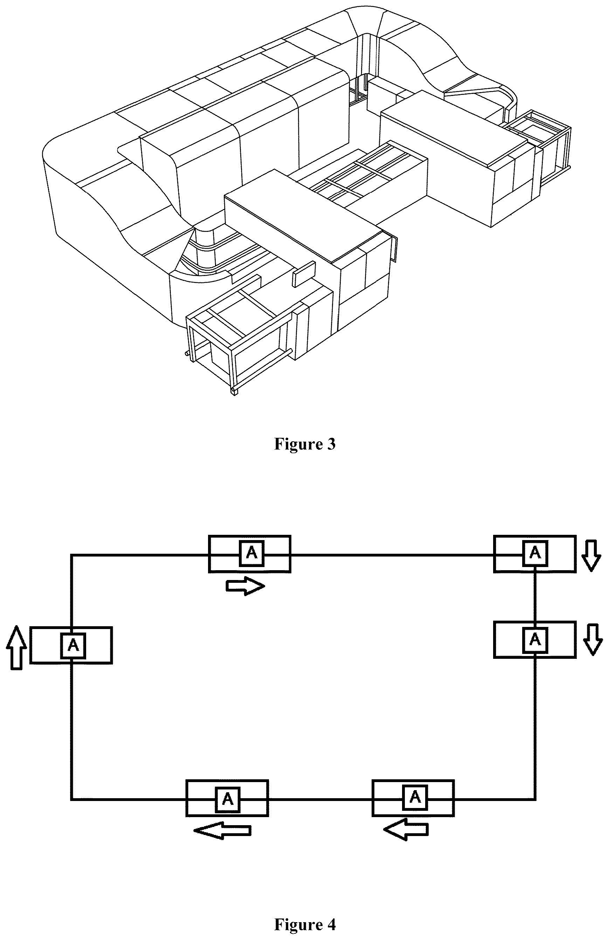

Un exemple similaire de tables aspirantes de l'art antérieur est décrit dans EP2351649 qui revendique un lit d'imprimante à jet d'encre dans lequel un objet d'impression placé sur un lit est fixé de manière stable au moyen d'une aspiration d'air et est imprimé. Tout comme la table décrite dans GB2511819, celle décrite dans les figures 3 et 4 de EP2351649 est caractérisée par une plaque supérieure représentative d'une sole aspirante traditionnelle percée de multitude de trous et, par des parois verticales de la couche nid d'abeilles percées de multitude de trous. De plus, ce type de table concerne des systèmes fixes/immobiles ce qui les éloignent des caractéristiques revendiquées dans la présente invention dont les tables répondent aux nouvelles exigences liées à leur déplacement le long d'un chemin de transport. Une machine d'impression sans contact avec un déplacement des substrats entre plusieurs postes de traitement par un chariot mobile est connue du document FR2827807A1.

### INVENTION - introduction

La présente invention propose ainsi un nouveau dispositif permettant de maintenir et de préférence de transporter des substrats imprimables et imprimés de manière précise, adaptés à des substrats de divers types, tailles et épaisseurs. En particulier, l'invention permet de réaliser des impressions à pas variable. En outre, la présente invention est adaptée aux machines d'impression sans contact avec le substrat, comme les machines d'impression à jet d'encre et, plus particulièrement les machines d'impression qui permettent de combiner, au sein d'une même machine, différents types d'impression et/ou différents types de séchage et/ou différents types de prétraitements et/ou différents types de post-traitements (ou de finitions) tels que, à titre purement illustratif et non limitatif, les impressions sans contact d'encres conventionnelles (noir, blanc, mono ou polychrome), et/ou de vernis, et/ou d'encres adaptées à l'électronique imprimée, et/ou d'encres adaptées à l'impression en trois dimensions et/ou d'encres diverses et variées comme par exemple les encres fonctionnelles et/ou les encres isolantes (par exemple les encres isolantes utilisées en aval d'une impression d'encre pour l'électronique imprimée); et/ou les séchages comportant par exemple un four de séchage à infrarouge (IR) et/ou à proche-infrarouge (NIR) et/ou à courant d'air chauffé, et/ou un séchage à lampe ultra-violet (UV) et/ou à diode électroluminescente (LED) UV et/ou un procédé photonique ; et/ou un prétraitement comme par exemple un poste de traitement corona, et/ou un poste de traitement plasma, et/ou un système de nettoyage de bande (rouleau nettoyeur, brosse, etc.), et/ou un poste de coating (flexographie, etc.), et/ou un système de retournement de feuilles ; et/ou un post-traitement (ou finition) dans un poste de revêtement (par exemple par dépôt d'un revêtement additionnel, par exemple dorure ou autre matière) sur le substrat, par exemple au moyen d'un dispositif de dépôt de « dorure », par exemple en appliquant/pressant une feuille (portant ledit revêtement ou dorure) sur des zones sélectionnées du substrat (par exemple comportant un dépôt d'adhésif selon un motif prédéterminé) de manière à faire adhérer aux zones sélectionnées la partie désirée de la feuille de type dorure ; de plus, cette combinaison de plusieurs modes d'impressions et/ou de traitements divers au sein d'une même machine est rendue possible grâce au mode de maintien/transport de haute précision (par exemple pour répondre aux exigences d'impression de l'électronique imprimée) selon la présente invention tout en évitant que les composants du maintien/transport n'interfèrent avec les exigences d'efficacités de chacun des postes d'impressions et/ou de traitements de manière individuelle et/ou en combinaison (par exemple pour éviter qu'un poste de séchage n'affecte les performances d'un poste d'impression). La présente invention permet également de maintenir et/ou d'acheminer les substrats de tailles diverses entre tous les postes de traitement tout en répondant aux exigences liées aux différentes vitesses de chacun des postes de traitements ainsi qu'à des débits de fabrications suffisants pour permettre une application industrielle efficace et rentable.

### INVENTION - dispositif

A cet effet, l'invention concerne une machine d'impression comprenant un dispositif de maintien de substrats telle que définie dans la revendication 1.

En effet, la Demanderesse a identifié au cours de la mise au point et des perfectionnements développés pour le dispositif de la présente invention que la température de surface du substrat et donc la température de surface de la partie supérieure de la table de maintien avaient une influence non négligeable non seulement sur la qualité des impressions (et, en particulier, sur la qualité de l'impression pour l'électronique imprimée) mais également sur les performances du/des postes de séchage. Ainsi, selon l'invention, la table aspirante comprend une couche structurelle à nid d'abeille. La Demanderesse a en effet développé ce mode d'exécution essentiel de l'invention car la couche structurelle à nid d'abeille permet non seulement d'homogénéiser la température de surface mais également de mieux dissiper la dite température dans l'ensemble de la table. De plus, cette couche structurelle à nid d'abeille possède plusieurs fonctions/avantages additionnels parmi lesquels nous citerons à titre illustratif et non limitatif
- une surface supérieure suffisamment plane pour le maintien du substrat en position,
- de permettre le passage de l'air de manière à assurer une dépression derrière le substrat et donc un maintien optimal dans l'option table aspirante,
- de limiter les effets de conduction thermique avec le substrat de par sa faible surface de contact,
- de limiter les effets de conduction thermique avec les couches inférieures et supérieures de la table (ce qui s'est avéré particulièrement pertinent pour certains postes de traitement, par exemple le poste de séchage à infra-rouge),
- de participer à l'élimination des problèmes de vibrations rencontrés avec les dispositifs de maintien/transport de l'art antérieur,
ce qui permet donc d'améliorer le maintien/transport de substrats imprimables et/ou imprimés pour/sur l'ensemble des postes de traitement compris dans une machine d'impression sans contact avec le substrat, comme les machines d'impression à jet d'encre.

De plus, selon un mode d'exécution particulier de la présente invention, les dispositif revendiqués se différencient de l'art antérieur grâce à leur souplesse d'utilisation et grâce à une réduction des temps de fabrication ainsi que des coûts correspondants, ce qui les rend particulièrement attractifs, en particulier pour l'électronique imprimée, par exemple pour la fabrication de circuits imprimés. Ainsi, la présente invention ainsi que sa table aspirante revendiquée, avec ses caractéristiques telles que décrites dont nous citerons à titre d'exemple la couche structurelle à nid d'abeille, le treillis optionnel et l'absence de soles à multitude de trous, apportent des avantages très importants dans le domaine de l'impression pour l'électronique imprimée. En effet, la Demanderesse a constaté une amélioration majeure de la qualité et de la précision de l'impression car la table aspirante a une double action bénéfique non seulement sur l'impression mais encore sur le séchage de l'encre imprimée ce qui ouvre des domaines nouveaux à la présente invention telle que l'électronique imprimée et, en particulier, l'électronique imprimée d'étiquette d'identification par fréquence radio (RFID) avec ou sans puce (aussi appelés tags RFID ou tags RFID sans puce) ; sans vouloir être limité par cette explication, la Demanderesse pense que lors du séchage de l'électronique imprimée, par exemple lors du traitement par infrarouge (IR) et/ou par proche-infrarouge (NIR), l'effet localisé du traitement combiné à l'effet de dissipation de la chaleur au travers de la table permettent un meilleur recuit de l'encre qui peut, par exemple, se traduire par une conductivité améliorée. La table aspirante permet aussi d'adapter au mieux (en fonction du substrat et de l'impression/dépôt) la puissance et la vitesse du séchage. De plus, la table aspirante permet de dissiper la chaleur ce qui permet de limiter les déformations de certains substrats, voire de ne pas avoir de répercussions entre les différents postes de traitement (par exemple, le séchage à infrarouge (IR) avec le séchage ultraviolet (UV)).

A titre illustratif et non limitatif, la couche structurelle à nid d'abeille a une épaisseur « e » comprise entre 1 et 100 mm, par exemple entre 5 et 30 mm, de préférence entre 5 et 15 mm, par exemple de 8 mm; la taille des cellules (par exemple des alvéoles) est comprise entre 10 microns et 10 mm, par exemple entre 1 et 8 mm, de préférence entre 2 et 5 mm, par exemple de 3,6 mm ; l'épaisseur des parois des cellules (par exemple des alvéoles) est comprise entre 0,5 micron et 5 mm, par exemple entre 10 et 200 microns, de préférence entre 30 et 100 microns, par exemple de 50µm.

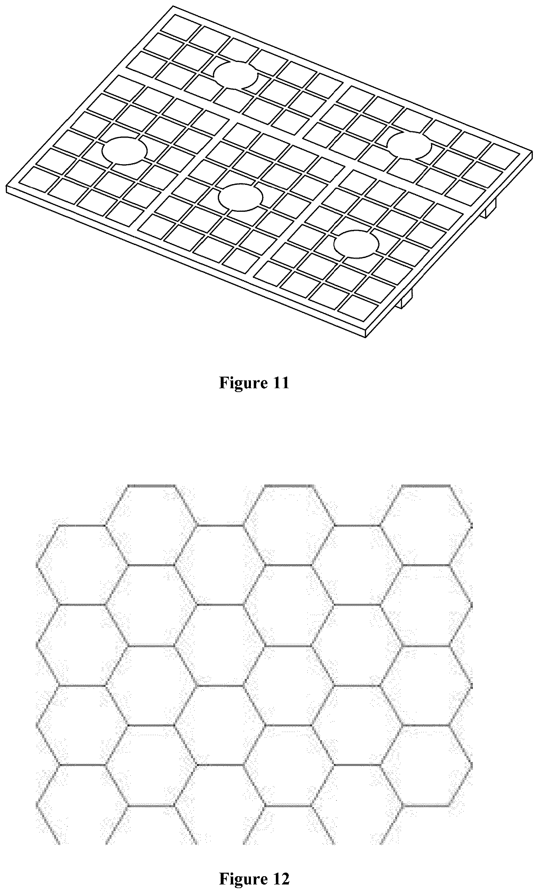

A titre illustratif et non limitatif, la couche structurelle à nid d'abeille est à pavage hexagonal régulier comme illustré sur la figure 12 ; elle est donc constituée de prismes droits à base hexagonale (qui ne comprennent donc de préférence pas de trous dans leurs parois verticales).

Les dimensions de surface de la couche structurelle à nid d'abeille seront sélectionnées en fonction des besoins et des applications et correspondront de préférence au moins à la surface du substrat (ou des substrats s'il y en a plusieurs maintenus sur la même table); nous citerons à titre illustratif des dimensions (1/L) en mm de l'ordre de 760/1070. Les largeurs/longueurs de cette couche structurelle à nid d'abeille (par exemple un cadre de forme parallélépipède rectangle de hauteur correspondant à l'épaisseur « e » susmentionnée) coïncideront de préférence avec celles de la couche d'aspiration passive décrite dans la description qui suit et, de préférence également avec celles de la couche d'aspiration active décrite dans la description qui suit.

Ainsi, selon un mode d'exécution particulier de la présente invention, la table (de préférence la table aspirante) comprend une couche structurelle à nid d'abeille telle que définie ci-dessus. L'utilisation de cette couche structurelle à nid d'abeille dans la table (de préférence la table aspirante) a permis de résoudre d'autres problèmes fondamentaux rencontrés dans les dispositifs de l'art antérieur. En effet, les techniques d'impression à jet d'encre (que ce soit au travers d'un poste d'impression d'encre conventionnelle ou spéciale (par exemple conductrice) et/ou un poste d'impression de vernis) requièrent bien souvent un séchage rapide de l'encre (ou du vernis) ce qui explique qu'au moins un poste de séchage suit directement un poste d'impression le long du chemin de transport de substrat. Cette disposition rapprochée est malheureusement peu compatible avec le bon fonctionnement des têtes d'impression car un séchage rapproché risque d'impacter sur les performances des dites têtes, par exemple par un effet de blocage des buses d'impression dû à la solidification intempestive de l'encre dans ces buses. Ainsi, il était nécessaire avec les techniques de l'art antérieur soit d'éloigner le poste de séchage du poste d'impression au risque de nuire à la qualité du rendu d'impression, soit de contrôler scrupuleusement le séchage, par exemple en diminuant la puissance de séchage, au risque de devoir limiter drastiquement les cadences d'impression et de nuire également à la qualité du rendu d'impression. Ces problèmes sont d'autant plus exacerbés pour le domaine de l'électronique imprimée. Ainsi, la Demanderesse a découvert que l'utilisation d'une couche structurelle à nid d'abeille (comme décrite ci-dessus) dans la table (de préférence la table aspirante) permettait de pallier à ces problèmes de l'art antérieur ce qui représente un avantage considérable pour le dispositif de maintien/transport selon la présente invention. En fait, sans vouloir être limité par cette explication, la Demanderesse pense que l'utilisation d'une couche structurelle à nid d'abeille (comme décrit ci-dessus) permet une dissipation optimale de la chaleur générée par le poste de séchage ainsi qu'une diminution drastique des phénomènes de réflexion et de transfert thermiques dans la table et/ou depuis la table vers les têtes d'impression ; à titre illustratif et non limitatif, la Demanderesse pense que l'utilisation d'une couche structurelle à nid d'abeille (comme décrit ci-dessus) permet par exemple de piéger les rayonnements UV du séchage pour qu'ils n'interfèrent pas (par réflexion) avec le bon fonctionnement des têtes d'impression et ne provoquent donc pas de durcissement de l'encre au sein des buses d'impression. De plus, et ceci constitue un autre avantage selon la présente invention, l'utilisation d'une couche structurelle à nid d'abeille (comme décrit ci-dessus) permet de s'affranchir des soles aspirantes de l'art antérieur telles que par exemple celles décrites dans la description qui suit (soles habituellement faites majoritairement de métal et/ou de polytétrafluoroéthylène (aussi connu sous le nom de Téflon) et percées de multitudes de trous) ; en effet, la couche structurelle à nid d'abeille (comme décrit ci-dessus) peut directement servir de sole de maintien pour les substrats et permettre ainsi à la table d'exercer l'aspiration et donc le maintien des dits substrats sur cette sole, la dite aspiration s'effectuant de préférence de manière à ce que la direction de l'écoulement de l'air au travers de la couche structurelle à nid d'abeille soit verticale.

Dans un mode d'exécution particulier de la présente invention, la couche structurelle à nid d'abeille est fixée de manière amovible sur la table ce qui permet de la remplacer et/ou de la changer en fonction, par exemple, des types de substrats utilisés. Tout système de fixation amovible pourra avantageusement être utilisé ; nous citerons à titre illustratif une fixation de type grenouillère et/ou de type clipsable.

Selon une variante de réalisation de la présente invention, la couche structurelle à nid d'abeille est faite en aluminium ; il est évident que l'homme de l'art saura sélectionner d'autres matériaux, similaires ou non à l'aluminium, qui répondront également aux exigences de la présente invention, par exemple de l'acier et/ou toute matière plastique et/ou composite et/ou céramique appropriée.

Selon une variante de réalisation de la présente invention, la couche structurelle à nid d'abeille n'est pas sandwichée, c'est-à-dire ne comprend pas de sous-couche inférieure et/ou supérieure ; cette variante est préférée dans le cas d'une table aspirante pour ne pas perturber l'aspiration au travers des cellules (par exemple des alvéoles).

L'invention concerne donc également un dispositif de transport de substrats dans une machine d'impression comprenant un ou plusieurs postes de traitement dont au moins un poste d'impression, le long d'un chemin de transport depuis au moins une zone (par exemple un magasin) d'entrée fournissant les substrats imprimables et/ou imprimés, jusqu'à au moins une zone (par exemple un magasin) de sortie recevant les substrats traités, comprenant :
1. un convoyeur de substrats (de préférence de type carrousel) permettant de guider et déplacer les substrats au travers des postes de traitement, le dit convoyeur comprenant des chariots qui maintiennent les substrats dans une position immobile (par exemple immobile et à plat) et qui se déplacent le long du chemin de transport en transportant les substrats,
2. une zone d'entrée des substrats (par exemple un magasin d'entrée de stockage des substrats),
3. un système de transport optionnel des substrats de la zone d'entrée jusqu'au chariot,
4. un système de transport optionnel des substrats traités du chariot jusqu'à la zone de sortie des substrats (par exemple le magasin de sortie),
5. une zone de sortie des substrats traités (par exemple un magasin de sortie de stockage des substrats traités),
6. une voie de garage optionnelle pour les chariots, la dite voie étant reliée de manière amovible au chemin de transport du convoyeur et permettant ainsi de parquer et/ou d'ajouter et/ou d'enlever un ou plusieurs chariots,
et caractérisé en ce que
1. le dispositif de transport de substrats comprend un système de motorisation qui permet le déplacement des chariots le long du chemin de transport,
2. le chariot comprend une table (de préférence une table aspirante) de maintien du substrat dans une position immobile par rapport à la table (par exemple immobile et à plat), le long du chemin de transport pendant le(s) traitement(s) du substrat, et
3. la table de maintien comprend une couche structurelle à nid d'abeille. D'autres particularités et avantages du dispositif de transport de substrats sont détaillés dans la présente demande. Un objectif supplémentaire non couvert par les revendications est de proposer un procédé de transport de substrats imprimables.

A cet effet, l'invention concerne également un procédé de transport de substrats le long d'un chemin de transport, mis en oeuvre par le dispositif de transport de substrats selon l'invention. En particulier, l'invention concerne également un procédé de transport de substrats dans une machine d'impression comprenant un ou plusieurs postes de traitement dont au moins un poste d'impression, le long d'un chemin de transport depuis au moins une zone (par exemple un magasin) d'entrée fournissant les substrats imprimables, jusqu'à au moins une zone (par exemple un magasin) de sortie recevant les substrats traités, caractérisé en ce qu'il comporte les étapes suivantes :
1. positionnement optionnel d'un substrat imprimable dans la zone d'entrée (par exemple stockage d'un substrat imprimable dans un magasin d'entrée),
2. transport optionnel du substrat de la zone d'entrée jusqu'au chariot,
3. guidage et déplacement du substrat au travers des postes de traitement par un convoyeur de substrats (de préférence de type carrousel), le dit convoyeur comprenant des chariots qui maintiennent les substrats dans une position immobile (par exemple immobile et à plat) et qui se déplacent le long du chemin de transport en transportant les substrats,
4. transport optionnel du substrat traité du chariot jusqu'à la zone de sortie (par exemple jusqu'au magasin de sortie et de stockage des substrats traités),
5. déplacement optionnel de chariots vers une voie de garage, la dite voie étant reliée de manière amovible au chemin de transport du convoyeur ce qui permet de parquer et/ou d'ajouter et/ou d'enlever un ou plusieurs chariots du convoyeur,
le procédé de transport de substrats étant ainsi adapté pour mouvoir chaque chariot de manière à le déplacer le long du chemin de transport et caractérisé en ce que
1. le dispositif de transport de substrats comprend un système de motorisation qui permet le déplacement des chariots le long du chemin de transport,
2. le chariot comprend une table sur laquelle le substrat est maintenu dans une position immobile par rapport à table (par exemple immobile et à plat) le long du chemin de transport pendant le(s) traitement(s) du substrat, et
3. la table comprend une couche structurelle à nid d'abeille.

Selon une variante « VAR1-DISP » de réalisation, la présente invention concerne également un dispositif de transport de substrats dans une machine d'impression comprenant un ou plusieurs postes de traitement dont au moins un poste d'impression, le long d'un chemin de transport depuis au moins une zone (par exemple un magasin) d'entrée fournissant les substrats imprimables et/ou imprimés, jusqu'à au moins une zone (par exemple un magasin) de sortie recevant les substrats traités, comprenant :
1. un convoyeur de substrats (de préférence de type carrousel) permettant de guider et déplacer les substrats au travers des postes de traitement, le dit convoyeur comprenant
   a. un rail fixe qui forme une boucle de transport, et
   b. des chariots qui maintiennent les substrats dans une position immobile (par exemple immobile et à plat) et qui se déplacent sur le dit rail en transportant les substrats et,
2. une zone d'entrée des substrats (par exemple un magasin d'entrée de stockage des substrats),
3. un système de transport optionnel des substrats de la zone d'entrée jusqu'au chariot,
4. un système de transport optionnel des substrats traités du chariot jusqu'à la zone de sortie des substrats (par exemple le magasin de sortie),
5. une zone de sortie des substrats traités (par exemple un magasin de sortie de stockage des substrats traités),
6. une voie de garage optionnelle pour les chariots, la dite voie étant reliée de manière amovible au rail du convoyeur et permettant ainsi de parquer et/ou d'ajouter et/ou d'enlever un ou plusieurs chariots,
le dispositif de transport de substrats étant ainsi adapté pour mouvoir chaque ensemble chariot/substrat de manière à le déplacer au moyen du chariot sur le rail le long de la boucle de transport et caractérisé en ce que
1. le dispositif de transport de substrats comprend un socle sur lequel au moins une partie du rail est fixée et dont la surface est de préférence plane,
2. le dispositif de transport de substrats comprend un système de motorisation qui permet le déplacement des chariots sur le rail fixe,
3. le chariot comprend une table (de préférence une table aspirante) de maintien du substrat dans une position immobile par rapport à la table (par exemple immobile et à plat), le long de la boucle de transport pendant le(s) traitement(s) du substrat, et 4. la table comprend une couche structurelle à nid d'abeille.

Ainsi, dans une variante de réalisation de la présente invention, le dispositif de transport de substrats est caractérisé en ce que le chemin de transport est une boucle de transport, en ce que le convoyeur comprend un rail fixe qui forme la dite boucle de transport et en ce que les chariots qui maintiennent les substrats dans une position immobile se déplacent sur le dit rail en transportant les substrats, le dispositif de transport de substrats étant ainsi adapté pour mouvoir chaque chariot sur le rail le long de la boucle de transport et en ce que
1. le dispositif de transport de substrats comprend un socle sur lequel au moins une partie du rail est fixée et dont la surface est de préférence plane, et
2. le dispositif de transport de substrats comprend un système de motorisation qui permet le déplacement des chariots sur le rail fixe.

Selon une variante « VAR1-PROC » de réalisation, non couverte par les revendications, l'invention concerne également un procédé de transport de substrats le long d'un chemin de transport, mis en oeuvre par le dispositif de transport de substrats selon la variante de réalisation « VAR1-DISP » selon l'invention. En particulier, l'invention concerne également (selon une autre variante « VAR2-PROC » de réalisation non couverte par les revendications) un procédé de transport de substrats dans une machine d'impression comprenant un ou plusieurs postes de traitement dont au moins un poste d'impression, le long d'un chemin de transport depuis au moins une zone (par exemple un magasin) d'entrée fournissant les substrats imprimables, jusqu'à au moins une zone (par exemple un magasin) de sortie recevant les substrats traités, caractérisé en ce qu'il comporte les étapes suivantes :
1. positionnement optionnel d'un substrat imprimable dans la zone d'entrée (par exemple stockage d'un substrat imprimable dans un magasin d'entrée),
2. transport optionnel du substrat de la zone d'entrée jusqu'au chariot,
3. guidage et déplacement du substrat au travers des postes de traitement par un convoyeur de substrats (de préférence de type carrousel), le dit convoyeur comprenant
   a. un rail fixe qui forme une boucle de transport, et
   b. des chariots qui maintiennent les substrats dans une position immobile (par exemple immobile et à plat) et qui se déplacent sur le dit rail en transportant les substrats et,
4. transport optionnel du substrat traité du chariot jusqu'à la zone de sortie (par exemple jusqu'au magasin de sortie et de stockage des substrats traités),
5. déplacement optionnel de chariots vers une voie de garage, la dite voie étant reliée de manière amovible au rail du convoyeur ce qui permet de parquer et/ou d'ajouter et/ou d'enlever un ou plusieurs chariots du convoyeur,
le procédé de transport de substrats étant ainsi adapté pour mouvoir chaque chariot de manière à le déplacer sur le rail le long de la boucle de transport et caractérisé en ce que
1. le dispositif de transport de substrats comprend un socle sur lequel au moins une partie du rail est fixée et dont la surface est de préférence plane,
2. le dispositif de transport de substrats comprend un système de motorisation qui permet le déplacement des chariots sur le rail fixe,
3. le chariot comprend une table sur laquelle le substrat est maintenu dans une position immobile par rapport à table (par exemple immobile et à plat) le long de la boucle de transport pendant le(s) traitement(s) du substrat, et
4. la table comprend une couche structurelle à nid d'abeille.

Selon l'invention, le substrat est maintenu à plat dans une position immobile par rapport à la table ; toutefois, comme la présente invention peut également s'appliquer à des substrats de type feuilles mais également à tout autre type d'objet en trois dimensions (par exemple des cylindres , des stylos, des coques de téléphone, etc...), l'homme de l'art comprendra que l'invention pourra avantageusement aussi convenir à ces autres objets sans pour autant qualifier leur positionnement immobile d'étant « à plat » sur la table ; selon une variante de réalisation de la présente invention, la partie supérieure de la table comprendra une matrice comprenant des formes et/ou réceptacles dans lesquels ces autres types d'objets en trois dimensions pourront avantageusement être déposés et/ou fixés.

La présente invention concerne également l'utilisation du dispositif de maintien/transport de substrats revendiqués dans une machine d'impression comprenant au moins un poste d'impression sans contact, en particulier d'impression numérique à jet d'encre. Plus particulièrement, cette utilisation est effectuée dans une machine d'impression qui comprend au moins deux postes d'impressions sans contact différentes en série, les dites impressions étant sélectionnées parmi la liste suivante : impressions d'encres conventionnelles (noir, blanc, mono et/ou polychrome), et/ou de vernis, et/ou d'encres adaptées à l'électronique imprimée, et/ou d'encres adaptées à l'impression en trois dimensions et/ou d'encres diverses et variées comme par exemple les encres fonctionnelles et/ou les encres isolantes (par exemple les encres isolantes utilisées en aval d'une impression d'encre pour l'électronique imprimée) ; la combinaison en série (par exemple sur la boucle de transport) d'une impression d'encres conventionnelles, d'une impression d'encres adaptées à l'électronique imprimée (comme les encres conductrice à base ou non de nanoparticules) et d'une impression de vernis et/ou d'encres fonctionnelles et/ou d'encres isolantes, le tout étant effectué de préférence sur un même substrat, est une utilisation privilégiée par la présente invention.

De plus, selon un mode d'exécution particulier de la présente invention et, comme décrit plus en détail dans la suite de la description, les dispositif revendiqués se différencient de l'art antérieur grâce à leur souplesse d'utilisation et grâce à une réduction des temps de fabrication ainsi que des coûts correspondants, ce qui les rend particulièrement attractifs, en particulier pour l'électronique imprimée, par exemple pour la fabrication de circuits imprimés.

L'invention, avec ses caractéristiques et avantages, ressortira plus clairement à la lecture de la description faite en référence aux dessins annexés dans lesquels :
Les figures 1 à 13 illustrent de manière schématique plusieurs aspects et plusieurs modes de réalisation de l'invention.

La présente invention présente de nombreux avantages par rapport aux techniques de l'art antérieur. Ces avantages apportés par la présente invention seront mis en évidence plus avant dans la description détaillée des figures.

Dans un mode d'exécution préféré de la présente invention, le dispositif de maintien/transport (et donc la machine d'impression comprenant un ou plusieurs postes de traitement) est contrôlé par des moyens informatiques qui commandent notamment les différents postes de travail, et également qui collectent les informations des différents capteurs installés dans le dispositif. Ces moyens informatiques n'ont pas à être détaillés dans la présente demande et ils pourront par exemple être intégrés à la machine ou déportés dans un dispositif séparé. Les capteurs donnent par exemple, des informations de positions des substrats, des informations de configurations des substrats et/ou des informations de validation suite à une opération correctement effectuée ou non. Certaines informations nécessaires à la mise en oeuvre de l'invention peuvent également être enregistrées au préalable dans les moyens informatiques (par exemple via une saisie sur une interface par un opérateur). De telles informations peuvent par exemple concerner la forme et/ou les dimensions des substrats (par exemple leur épaisseur), la puissance du séchage, l'épaisseur de la couche de l'encre et/ou de vernis etc., mais il est généralement préféré que des capteurs mesurent ou vérifient de telles informations. Les substrats en attente d'impression sont généralement, de façon connue en soi, placés dans au moins une zone d'entrée, par exemple un magasin d'entrée ayant une capacité de stockage définie en fonction de la nature du substrat et des besoins pour l'impression. Dans un exemple de réalisation, un magasin d'entrée est prévu pour accepter plusieurs dizaines, centaines, voire milliers de substrats de nature, d'épaisseur et de dimension variable (par exemple et de façon non limitative d'un format dont les côtés sont de l'ordre du centimètre, par exemple un format type A10, à titre d'exemple plus précis un format type carte de crédit ; jusqu'au format dont les côtés sont de l'ordre de plusieurs mètres, par exemple un format type A0 ou un format de 2 x 2 mètres). Une fois le processus d'impression terminé, les substrats sont dirigés vers une zone de sortie, par exemple stockés dans au moins un magasin de sortie ayant généralement la même capacité de stockage que le magasin d'entrée.

Une caractéristique d'un mode particulier de la présente invention est donc l'utilisation d'un convoyeur de substrats (de préférence de type carrousel) permettant de guider et déplacer les substrats au travers des postes de traitement, le dit convoyeur comprenant des chariots qui maintiennent les substrats dans une position immobile (par exemple immobile et à plat) et qui se déplacent le long du chemin de transport, de préférence sur un rail fixe, ce qui permet de mouvoir chaque ensemble chariot/substrat sur le rail, et étant caractérisé en ce que le déplacement des chariots est contrôlé au moyen d'un système de motorisation, de préférence un système de motorisation linéaire. Cette motorisation linéaire est basée sur le principe d'une interaction électromagnétique entre un assemblage de bobines (ensemble primaire) et une voie d'aimants permanents (ensemble secondaire), interaction qui transforme l'énergie électrique en une énergie mécanique linéaire. Dans un mode d'exécution préféré de la présente invention, l'ensemble primaire moteur de la motorisation linéaire fait partie du chariot (mobile) et l'ensemble secondaire est constitué d'une voie d'aimants (appelée aussi voie magnétique), la dite voie étant fixée le long du chemin de transport ; dans des variantes de réalisation dont certaines seront décrites plus en détail ci-après dans la description, la dite voie est fixée sur le rail fixe (ou fait partie intégrante du rail fixe) et/ou est fixée sur le socle (ou fait partie intégrante du socle) et/ou est fixée sur une structure rigide de maintien du rail (ou fait partie intégrante de cette structure rigide); dans ces configurations, l'ensemble primaire d'un chariot se déplace donc à la même vitesse que le substrat transporté par le dit chariot. Le chariot est donc un chariot qu'on pourra qualifier de chariot intelligent et/ou autonome comme décrit ci-après dans la description.

La longueur de la voie d'aimants est de préférence similaire à la longueur du chemin de transport et/ou de la boucle de transport (par exemple la longueur du rail fixe). On pourra envisager des configurations dans lesquelles la voie d'aimant est située d'un côté ou de l'autre côté (ou de part et d'autre dans une configuration à plusieurs voies) du rail fixe. Ainsi, la longueur totale d'une voie d'aimants pourra avoir une longueur soit identique, soit légèrement supérieure, soit légèrement inférieure à celle du chemin de transport et/ou de la boucle de transport (par exemple celle du rail fixe) ; à titre purement illustratif et non limitatif, la voie d'aimants aura une longueur comprise entre 0,8 fois et 1,2 fois la longueur du chemin de transport et/ou de la boucle de transport (par exemple la longueur du rail fixe), de préférence entre 0,9 fois et 1,1 fois la longueur du chemin de transport et/ou de la boucle de transport (par exemple la longueur du rail fixe).

Les avantages liés à cette technologie de motorisation sont nombreux. A titre illustratif et non limitatif, nous citerons
- le couplage direct du chariot mobile à la partie mobile du moteur qui élimine le besoin d'éléments de transmission tels que les courroies d'entraînement, les engrenages sur crémaillères ou les engrenages à vis sans fin, les vis à billes, etc.
- il n'y a peu ou pas d'usure mécanique car il n'y a pas de contact avec les pièces en mouvement, ce qui engendre une excellente fiabilité et une longue durée de vie,
- la possibilité de contrôler de manière individuelle la vitesse et/ou l'accélération et/ou la décélération de chaque chariot; il est aussi important de noter que ce contrôle individuel peut se faire à tout moment et/ou en tout point de la boucle de transport ; il est aussi important de noter que ce contrôle individuel peut être différent pour chaque chariot pour un endroit donné,
- la réduction du nombre de composants mécaniques qui permet de minimiser la maintenance et de réduire ainsi le coût à l'utilisation de cette technologie.

La figure 1 illustre de manière schématique une vue d'ensemble du dispositif de transport de substrats selon la présente invention. On peut y apercevoir le convoyeur de substrats de type carrousel permettant de guider et déplacer les substrats, le dit convoyeur comprenant un rail fixe qui forme une boucle de transport fermée (un rectangle à coins arrondis dans la figure) ; des chariots (trois chariots dans la figure) qui maintiennent les substrats (trois substrats rectangulaires par chariot) dans une position immobile (à plat dans la figure) et qui se déplacent sur le dit rail en transportant les substrats ; le rail fixe central ainsi que la voie d'aimants positionné en son centre ; le socle fixe (dont la longueur est légèrement inférieure à une longueur du côté du rectangle formant la boucle de transport dans cette illustration) ; ainsi qu'une vue simplifiée des rails conducteurs d'électricité qui, dans cette configuration forment une boucle fermée (de même forme que la boucle de transport) de longueur supérieure à celle du rail fixe car située à l'extérieur de la boucle formée par le rail. Afin de faciliter la compréhension de cette figure, les postes de traitement n'y ont pas été représentés ; à titre purement illustratif le positionnement des postes d'impression le long de cette boucle de transport coïncidera avec la position du socle afin de bénéficier pleinement des avantages de la présente invention.

La figure 2 illustre de manière schématique une vue de l'ensemble secondaire qui est constitué d'une voie d'aimants (appelée aussi voie magnétique), la dite voie étant dans cette illustration fixée sur le rail fixe. On peut également identifier dans cette figure 2 le socle, les électro-aimants, le double guidage en V aux extrémités du rail fixe, ainsi que les deux glissières situées de part et d'autre du rail fixe, les dites glissières étant détaillées ci-après dans la description.

La figure 3 illustre de manière schématique une vue d'ensemble du dispositif de transport de substrats dans une machine d'impression comprenant plusieurs postes de traitement selon la présente invention. On peut y apercevoir le convoyeur de substrats de type carrousel permettant de guider et déplacer les substrats au travers des postes de traitement, le dit convoyeur comprenant un rail fixe qui forme une boucle de transport fermée, et des chariots (non illustrés) qui maintiennent les substrats dans une position immobile (par exemple à plat) et qui se déplacent sur le dit rail en transportant les substrats, un magasin d'entrée de stockage des substrats à gauche de la figure, un système de transport des substrats du magasin d'entrée jusqu'au chariot, un système de transport des substrats traités du chariot jusqu'au magasin de sortie, et un magasin de sortie de stockage des substrats traités à droite de la figure. Le bloc « Alphajet » situé en haut à gauche de la figure et positionné dans cette configuration à l'intérieur de la boucle correspond aux postes d'impression et de séchage ; en particulier dans cette configuration une combinaison en série d'une impression d'encres conventionnelles, d'une impression d'encres adaptées à l'électronique imprimée (comme les encres conductrice à base ou non de nanoparticules) et d'une impression de vernis et/ou d'encres fonctionnelles et/ou d'encres isolantes.

Une caractéristique d'une variante préférée de la présente invention est donc l'utilisation d'un convoyeur de substrats (de préférence de type carrousel) permettant de guider et déplacer les substrats au travers des postes de traitement, le dit convoyeur comprenant des chariots qui maintiennent les substrats dans une position immobile (par exemple à plat) et qui se déplacent le long du chemin de transport (par exemple sur un rail fixe) qui forme une boucle de transport, par exemple une boucle de transport fermée. La forme de la boucle de transport pourra être de tout type approprié. Sa longueur sera elle-même déterminée en fonction du nombre de postes de traitement compris dans la machine d'impression. En particulier, la machine d'impression selon la présente invention comprend au moins un poste d'impression sans contact avec le substrat (par exemple deux, trois, quatre ou plus de postes d'impression) et au moins un poste de séchage (par exemple deux, trois, quatre ou plus de postes de séchage); le poste d'impression pouvant avantageusement être sélectionné parmi un poste d'impression à jet d'encres conventionnelles (noir, blanc, mono et/ou polychrome) et/ou un poste d'impression à jet de vernis, et/ou un poste d'impression à jet d'encre adaptée à l'électronique imprimée (par exemple de l'encre conductrice à base ou non de nanoparticules), et/ou un poste d'impression à jet d'encre adaptée à l'impression en trois dimensions et/ou un poste d'impression à jet d'encres diverses et variées comme par exemple les encres fonctionnelles et/ou les encres isolantes (par exemple les encres isolantes utilisées en aval d'une impression d'encre pour l'électronique imprimée) ; le poste de séchage pouvant avantageusement être sélectionné parmi un poste de séchage à infrarouge (IR) et/ou un poste de séchage à proche-infrarouge (NIR) et/ou un poste de séchage à courant d'air chauffé, et/ou un poste de séchage à lampe ultra-violet (UV) et/ou un poste de séchage à diode électroluminescente (LED) UV et/ou un poste de séchage par procédé photonique. On citera à titre illustratif et non limitatif l'utilisation optionnelle d'un ou plusieurs postes de prétraitement comme par exemple un poste de traitement corona, et/ou un poste de traitement plasma, et/ou un système de nettoyage de bande (rouleau nettoyeur, brosse, etc.), et/ou un poste de coating (flexographie, etc.), et/ou un système de retournement de feuilles ; et/ou l'utilisation optionnelle d'un ou plusieurs postes de post-traitement (ou de finition) comme par exemple un système de retournement de feuilles et/ou un poste de revêtement (par exemple par dépôt d'un revêtement additionnel, par exemple dorure ou autre matière) sur le substrat, par exemple au moyen d'un dispositif de dépôt de « dorure », par exemple en appliquant/pressant une feuille (portant ledit revêtement ou dorure) sur des zones sélectionnées du substrat (par exemple comportant un dépôt d'adhésif selon un motif prédéterminé) de manière à faire adhérer aux zones sélectionnées la partie désirée de la feuille de type dorure. Cette combinaison de plusieurs modes d'impressions et/ou de traitements divers au sein d'une même machine est rendue possible grâce au mode de transport de haute précision selon la présente invention tout en évitant que les composants du transport n'interfèrent avec les exigences d'efficacités de chacun des postes d'impressions et/ou de traitements de manière individuelle et/ou en combinaison. La présente invention permet ainsi d'acheminer les substrats de dimensions/tailles diverses entre tous les postes de traitement tout en répondant aux exigences liées aux vitesses (qu'elles soient différentes ou identiques) requises lors des passages des substrats dans chacun des postes de traitements ainsi qu'à des débits de fabrications suffisants pour permettre une application industrielle efficace et rentable. La technologie de motorisation, en particulier la technologie de motorisation linéaire, utilisée pour le transport des substrats permet de contrôler de manière individuelle la vitesse de chaque chariot ; cela permet ainsi sur demande d'accélérer ou de décélérer la vitesse d'un chariot, ou encore de modifier la vitesse relative d'un chariot par rapport à un autre chariot. Ainsi, dans un mode d'exécution particulier de la présente invention, au temps « t » la vitesse d'au moins un chariot (de transport des substrats) en mouvement le long de la boucle de transport est différente de la vitesse d'un autre chariot (de transport des substrats) en mouvement le long de la boucle de transport; par exemple, la vitesse d'au moins un chariot de transport des substrats en mouvement au travers d'un poste de traitement est différente de la vitesse d'un chariot de transport des substrats en mouvement soit au travers d'un autre poste de traitement de la boucle de transport, soit au travers d'autres sections de la boucle de transport. Cette possibilité de contrôler de manière individuelle la vitesse et/ou l'accélération et/ou la décélération de chaque chariot lors de son déplacement le long du chemin de transport représente un avantage exceptionnel selon la présente invention. Ceci permet de bénéficier pleinement des performances de chacun des postes de traitement en adaptant la vitesse du chariot au type de traitement souhaité. Dans un mode d'exécution particulier, la présente invention permet donc également de réaliser des impressions et/ou des séchages et/ou des traitements divers à pas variable.

Dans un mode d'exécution particulier de la présente invention, la boucle de transport ne comprend pas d'angle droit ; au contraire, sa forme sera préférentiellement sélectionnée de manière à ne comprendre que des parties droites linéaires jointes au moyen de courbes (« arcs ») de forme libre.

D'autres variantes d'exécution sont bien entendu envisageables pour la boucle de transport. On citera à titre illustratif la variante de la figure 4 dans laquelle les chariots n'effectuent pas de courbes (virages) lors de leur déplacement le long du carrousel; on peut y apercevoir la boucle de type carrousel, six chariots supportant chacun un substrat « A », chaque substrat étant immobile sur son chariot attitré ainsi que le sens de déplacement, représenté par des flèches, de chacun des chariots.

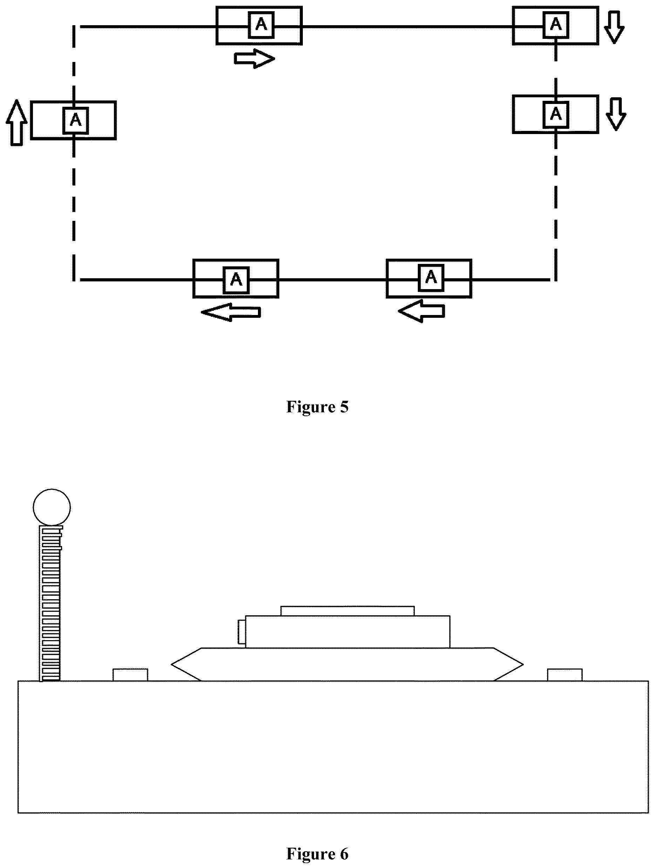

On citera également à titre illustratif la variante de la figure 5 dans laquelle les chariots n'effectuent pas de courbes (virages) lors de leur déplacement et la boucle comprend au moins un rail (par exemple 2 rails parallèles) situé(s) à une certaine hauteur et au moins un rail (par exemple 2 rails parallèles) perpendiculaire(s) au premier rail et situés à une autre hauteur ce qui impliquent l'utilisation d'un système permettant d'élever et/ou de descendre le chariot (comme un ascenseur) pour passer d'un rail à l'autre.

Même si ces variantes ne sont pas privilégiées dans le cadre de la présente invention, elles pourraient néanmoins s'avérer utiles, par exemple dans le cas où on serait limité en matière d'espace disponible pour installer le dispositif de transport et que donc l'encombrement nécessiterait des solutions de transport plus compactes.

Dans un mode d'exécution particulier de la présente invention, la boucle de transport est de forme carrée ou rectangle avec des coins arrondis.

Dans un mode d'exécution particulier de la présente invention, les postes de traitement, par exemple les postes d'impression et/ou de séchage sont localisés dans une partie droite linéaire de la boucle de transport.

Le sens de rotation habituel des chariots le long de la boucle de transport est en général défini en fonction de l'agencement des postes d'impression et/ou de séchage et/ou d'autres postes de traitement(s) des substrats. Il peut donc être de sens horaire ou antihoraire. Un autre avantage de la technologie à motorisation linéaire selon la présente invention est que le sens de rotation peut être inversé si nécessaire. Ainsi, dans un mode d'exécution particulier de la présente invention, le chariot et le(s) substrat(s) maintenu(s) dans une position immobile (par exemple à plat) sur le chariot peuvent se déplacer dans les deux sens le long du chemin de transport, par exemple dans les deux sens de rotation sur la boucle de transport. Cette caractéristique permet par exemple d'effectuer plus d'un passage dans un poste d'impression et/ou un poste de séchage et/ou un autre poste de traitement des substrats, et/ou dans une combinaison de deux ou plusieurs ou de tous ces postes précités. Cette flexibilité peut s'avérer particulièrement avantageuse par exemple en cas de performance inférieure temporaire ou en fonction du type de poste de traitement concerné ; à titre illustratif et non limitatif, un poste de traitement peut requérir un passage répété du substrat de manière à atteindre la résolution d'impression désirée (pour un poste d'impression) et/ou la qualité de séchage désirée (par exemple pour un poste de séchage dont on ne désirerait pas augmenter la puissance de séchage) et/ou de devoir effectuer du multi passes alors que d'autres postes de traitement n'en auront pas besoin. Le contrôle des mouvements des chariots de manière autonome constitue donc un avantage considérable de la présente invention. Le chariot est donc un chariot qu'on pourra qualifier de chariot intelligent et/ou autonome comme décrit dans la présente description.

En principe, les substrats n'effectuent sur leur chariot sélectionné qu'un passage le long du chemin de transport, par exemple que le tour de la boucle de transport, depuis leur maintien dans une position immobile (par exemple à plat) sur le chariot à proximité du magasin d'entrée et de stockage des substrats jusqu'à leur point d'enlèvement du même chariot à proximité du magasin de sortie et de stockage des substrats traités.

Toutefois, et ceci représente un avantage additionnel de la présente invention, deux voir même plusieurs passages le long du chemin de transport, et/ou plusieurs tours de la boucle de transport, sont envisageables pour le substrat. Ainsi, dans un mode particulier de la présente invention, le substrat peut effectuer plus d'un passage dans un poste d'impression et/ou un poste de séchage et/ou un autre poste de traitement des substrats, et/ou dans une combinaison de deux ou plusieurs ou de tous ces postes précités, sans quitter son chariot. Cette caractéristique peut s'avérer particulièrement utile lorsqu'un poste d'impression et/ou un poste de séchage et/ou un autre poste de traitement des substrats n'atteint pas les performances requises, par exemple en matière de résolution de l'image imprimée pour un poste d'impression ; ainsi, un deuxième passage sous le poste à performance inférieure permettra de résoudre le problème identifié sans devoir changer dans l'urgence le poste défaillant.

Une caractéristique préférée d'une variante de réalisation de la présente invention est donc l'utilisation d'un convoyeur de substrats (de préférence de type carrousel) permettant de guider et déplacer les substrats au travers des postes de traitement, le dit convoyeur comprenant un ou plusieurs chariots qui maintiennent les substrats dans une position immobile (par exemple à plat) et qui se déplacent sur un rail fixe le long du chemin de transport (par exemple le long de la boucle de transport) pendant les traitements du substrat, et caractérisé en ce qu'au moins une partie du rail est fixée sur un socle dont la surface est de préférence plane ; la longueur du rail fixe étant de préférence identique à celle du chemin de transport (par exemple de la boucle de transport).

La figure 6 illustre de manière schématique cet ensemble socle - rail. On peut y apercevoir à titre illustratif un socle en granite qui constitue la base en gris foncé sur lequel un rail fixe à double guidage en V est fixé ; il y a une pièce de maintien optionnelle qui est fixée sur le rail fixe, pièce sur laquelle sont fixées - sur sa gauche une règle qui sera décrite dans la description ci-dessous - et sur son dessus, la voie d'aimants déjà décrite ci-avant. Cette figure 6 illustre également de manière très schématique des éléments qui seront décrits plus en détail dans la description ci-dessous, à savoir, de part et d'autre du rail fixe des glissières fixées sur le socle et à l'extrémité gauche de la figure un ensemble de rails conducteurs d'électricité surmonté par un câble rayonnant de transfert de données (d'informations).

Les dimensions du socle seront sélectionnées en fonction des besoins et des applications. A titre illustratif et non limitatif, pour les applications industrielles particulièrement visées par le type de dispositif revendiqué, la surface plane supérieure du socle sera disposée à une hauteur du sol comprise entre 50 cm et 80 cm et aura une largeur transversale comprise entre 40 cm et 120 cm, par exemple entre 60 cm et 100 cm, et une longueur comprise entre 200 cm et 1200 cm, par exemple 500 cm et 800 cm.

Dans un mode d'exécution particulier de la présente invention, la longueur totale du(des) socle(s) du dispositif de transport est sélectionnée de manière à couvrir tout l'espace situé en-dessous des postes d'impression de la boucle de transport. Plus particulièrement, si la valeur de la longueur totale des postes d'impression est X, la longueur totale du(des) socle(s) du dispositif de transport sera d'au moins X, de manière à garantir la planéité recherchée sous les postes d'impression ; toutefois, comme ce(s) socle(s) représentent un poids et un investissement financier importants, on préfèrera limiter leur longueur totale à des valeurs inférieures à 3 fois X, de préférence inférieures à 2 fois X, par exemple inférieure à 1,5 fois X, voir inférieure à 1,2 fois X.

Dans un mode d'exécution particulier de la présente invention, la longueur totale du(des) socle(s) du dispositif de transport est également sélectionnée de manière à couvrir tout l'espace situé en-dessous des postes de séchage de la boucle de transport. Plus particulièrement, si la valeur de la longueur totale des postes de séchage est Y et la valeur de la longueur totale des postes d'impression est X, la longueur totale du(des) socle(s) du dispositif de transport sera d'au moins (X+Y), de manière à garantir la planéité recherchée sous les postes de séchage et d'impression; toutefois, comme ce(s) socle(s) représentent un poids et un investissement financier importants, on préfèrera limiter leur longueur totale à des valeurs inférieures à 3 fois (X+Y), de préférence inférieures à 2 fois (X+Y), par exemple inférieure à 1,5 fois (X+Y), voir inférieure à 1,2 fois (X+Y).

Dans un mode d'exécution particulier de la présente invention, la longueur totale du(des) socle(s) du dispositif de transport est également sélectionnée de manière à couvrir tout l'espace situé en-dessous des autres postes de traitement (les postes qui ne sont ni d'impression, ni de séchage) de la boucle de transport comme, à titre illustratif, les postes de pré- et/ou post-traitements. Plus particulièrement, si la valeur de la longueur totale des autres postes de traitement est de Z, la valeur de la longueur totale des postes de séchage est Y et la valeur de la longueur totale des poste d'impression est de X, la longueur totale du(des) socle(s) du dispositif de transport sera d'au moins (X+Y+Z), de manière à garantir la planéité recherchée sous tous les postes de séchage, d'impression et d'autres traitements ; toutefois, comme ce(s) socle(s) représentent un poids et un investissement financier importants, on préfèrera limiter leur longueur totale à des valeurs inférieures à 3 fois (X+Y+Z), de préférence inférieures à 2 fois (X+Y+Z), par exemple inférieure à 1,5 fois (X+Y+Z), voir inférieure à 1,2 fois (X+Y+Z).

Dans une variante de réalisation selon la présente invention, la longueur totale du(des) socle(s) du dispositif de transport est inférieure à la moitié de la longueur du chemin de transport (par exemple de la boucle de transport), inférieure à 0,4 fois la longueur du chemin de transport (par exemple de la boucle de transport), par exemple inférieure au tiers de la longueur du chemin de transport (par exemple de la boucle de transport).

Dans un mode d'exécution particulier de la présente invention et, plus particulièrement, en fonction de la longueur du chemin de transport (par exemple de la boucle de transport) et/ou de la disposition des postes d'impression et/ou de séchage et/ou d'autres traitements, un, deux ou plusieurs socles seront disposés dans le dispositif de transport.

Le socle, sa planéité et ses dimensions représentent donc des caractéristiques importantes selon certaines variantes de la présente invention. Ainsi, le socle constitue la base stable/l'assise solide du chariot (et/ou du rail) le long du chemin de transport (par exemple le long de la boucle de transport) aux endroits les plus critiques comme sous les postes d'impression. Plus particulièrement, la Demanderesse a constaté que le socle permettait de résoudre efficacement les problèmes de vibrations rencontrés avec les dispositifs de transport de l'art antérieur, ce qui permet donc d'améliorer le transport de substrats imprimables et/ou imprimés sur l'ensemble des postes de traitement compris dans une machine d'impression, en particulier une machine d'impression sans contact avec le substrat, comme les machines d'impression à jet d'encre. Ceci explique le choix d'une roche ferme polissable, dénommée de manière générique par du marbre, comme par exemple du granite, et/ou basalte, et/ou porphyre, et/ou serpentinite, ... et/ou des gneiss, et/ou des grès, ct/ou des brèches, et/ou des calcaires et/ou autres conglomérats, comme élément(s) constitutif(s) d'un socle utilisé dans une variante de réalisation préférée selon la présente invention. Il est évident que l'homme de l'art saura sélectionner d'autres matériaux, similaires ou non au marbre, qui répondront également aux exigences d'absence de vibrations afin de garantir la qualité des impressions ; on citera à titre illustratif le granit (terme générique utilisé dans la construction et désignant tout matériau naturel ayant l'aspect d'une roche qui est en général très dure et très résistante à l'usure), et/ou les pierres composites et/ou les céramiques et/ou les céramiques techniques et/ou la fonte. La Demanderesse a constaté que les rapports de poids entre le socle, le chariot et le(s) substrat(s) constituaient également des caractéristiques importantes permettant de combattre les vibrations du dispositif de transport ; ainsi, dans une variante de réalisation de la présente invention, le rapport entre le poids d'un chariot de longueur L et le poids d'une longueur L du socle sera inférieur à 0,3 , par exemple inférieur à 0,2 ; dans une variante de réalisation de la présente invention, le rapport entre le poids [d'un chariot de longueur L et des substrats disposés sur le dit chariot] et le poids d'une longueur L du socle sera inférieur à 0,3 , par exemple inférieur à 0,2.

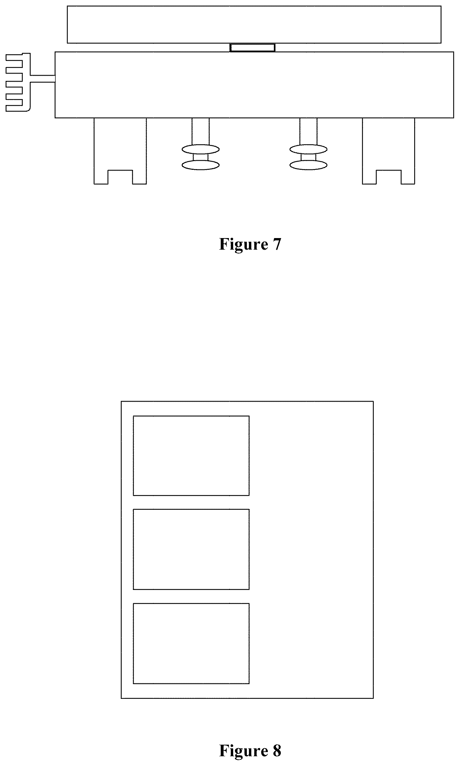

Tout système de guidage des chariots le long du chemin de transport (par exemple sur le rail) pourra avantageusement être utilisé dans le cadre de la présente invention. Dans un mode d'exécution particulier de la présente invention, le système de guidage des chariots sur le rail est sélectionné parmi les systèmes de guidage en V ; de préférence comportant un double guidage en V comme illustré dans les figures 6 (rail dont les extrémités sont en V « mâle ») et la figure 7 (roues en V « femelles » fixées au chariot). Dans un mode d'exécution particulier de la présente invention, le chariot comprend au moins une roue en V, de préférence 2 roues en V, plus particulièrement au moins 4 roues en V.

Selon une variante préférée de réalisation de la présente invention, le système de guidage du chariot sur le rail comprend au moins un couple d'éléments de guidage disposés de part et d'autre du rail (par exemple des roues) ; chaque couple d'éléments de guidage (par exemple couple de roues) comprenant un mécanisme assurant le guidage du chariot à la fois dans les lignes droites et dans les virages. A titre illustratif et non limitatif, chaque couple d'éléments de guidage comprendra une barre de maintien qui relie les deux éléments de guidage entre eux (par exemple les deux roues entre elles), la dite barre de maintien comprenant un axe pivotant relié au chariot permettant d'assurer un guidage optimal du chariot le long du rail et, en particulier le long des virages formés par la boucle de transport.

Dans un mode particulier de l'invention, le système de guidage du chariot sur le rail comprend 3 éléments de guidage (par exemple 3 roues), 2 d'un côté du rail et 1 de l'autre côté du rail de manière à permettre au chariot de prendre les virages formés par la boucle de transport et également de suivre des directions linéaires.

La figure 7 illustre donc une variante de chariot selon la présente invention, le dit chariot comprenant, une base structurelle représentée en gris clair sur la figure surmontée d'une table (en gris foncé) de support des substrats qui sera détaillée ci-dessous dans la description ; on peut également apercevoir sous la base 2 roues en V entourées par deux patins des glissières qui seront détaillées ci-dessous dans la description et, à gauche de la base, un élément de contact glissant (servant à alimenter en énergie le chariot). Une variante de la figure 7 (non illustrée) sera de disposer les roues en V de telle sorte qu'elles entourent les patins des glissières, ce qui impliquera de préférence que les rails des glissières seront positionnés sur le rail fixe et que la hauteur des patins des glissières sera inférieure à celle des roues en V sous la base du chariot.

Dans un mode d'exécution particulier de la présente invention, le système de guidage des chariots comprend donc au moins un rail couplé au(x) roue(s) du chariot selon un dispositif de guidage en V ; ceci permet de guider la/les roue(s) en du chariot dans le(s) V du rail; de préférence un rail avec double guidage en V ce qui permet d'y guider les roues en V du chariot. Ainsi, dans un mode d'exécution particulier de la présente invention, le chariot est muni de 4 roues en V placées (de préférence de manière symétrique deux à deux par rapport au centre du chariot), deux des roues étant guidées par le V d'un côté du rail et les deux autres roues étant guidées par le V de l'autre côté du rail.

Dans un mode d'exécution particulier de la présente invention, le rail est positionné de manière centrale par rapport à la largeur du chariot et/ou la largeur du socle ; ainsi, dans une variante de réalisation de la présente invention le centre de la largeur du rail se trouve à une distance de moins de 20 cm, par exemple de moins de 15 cm du centre de la largeur du chariot ct/ou du centre de la largeur du socle. Dans un mode d'exécution particulier de la présente invention, le centre de la largeur de la voie d'aimants est aligné avec le centre de la largeur du rail fixe.

Ainsi, selon une caractéristique de la présente invention, au moins une partie du rail est fixée sur un socle ou fait partie intégrante du dit socle. On pourrait avantageusement utiliser un socle sur toute la longueur du rail pour sa fixation. Toutefois, comme ces socles et, en particulier les socles définis ci-dessus, représentent un poids et un investissement financier important, on peut aussi prévoir tout type approprié de structure rigide évidée pour la fixation du rail - ou pour l'intégration du rail dans ladite structure - le long du chemin de transport ; nous citerons à titre illustratif un châssis mécano-soudé et/ou un châssis en profilé. Dans un mode d'exécution particulier selon la présente invention, une structure rigide évidée est utilisée pour la fixation du rail (ou pour l'intégration du rail dans ladite structure) en dehors des postes d'impression et/ou des postes de séchage et/ou de tout autre poste de traitement des substrats. Ainsi, dans une variante de réalisation selon la présente invention, la longueur totale de la structure rigide évidée utilisée pour la fixation du rail du dispositif de transport est supérieure ou égale à la moitié de la longueur du chemin de transport (par exemple de la boucle de transport), supérieure ou égale à 0,6 fois la longueur du dit chemin (de la boucle de transport), par exemple supérieure ou égale au deux tiers du dit chemin (de la longueur de la boucle de transport).

Dans un mode d'exécution préféré de la présente invention, le dispositif de transport est équipé d'au moins un système de détection (ou capteur) de déplacement, de préférence un système de détection (ou capteur) de déplacement linéaire, pour mesurer le déplacement (position, vitesse, accélération et/ou décélération) du chariot le long du chemin de transport, par exemple par rapport au rail fixe. Tout système de détection (ou capteur) de déplacement satisfaisant les exigences de précision requises pourra avantageusement être utilisé dans le dispositif selon la présente invention. On citera à titre illustratif et non limitatif un capteur de déplacement comportant une partie mobile et une partie fixe, par exemple une règle optique. Dans un mode d'exécution préféré de la présente invention, la partie fixe du capteur de déplacement (par exemple la règle optique) consiste de préférence en une règle linéaire de préférence positionnée le long du chemin de transport (de la boucle de transport) sous les postes d'impression et/ou les postes de séchage et/ou sous tout autre poste de traitement des substrats nécessitant une précision accrue de mesure de position, vitesse, accélération et/ou décélération du chariot le long du chemin de transport (de la boucle de transport), de préférence sous les postes d'impression. Cette règle (de préférence linéaire) peut donc avantageusement faire partie intégrante du rail et/ou être fixée sur le rail et/ou être fixée sur le socle du rail et/ou faire partie intégrante du socle du rail et/ou être fixée sur la structure du rail et/ou faire partie intégrante de la structure du rail. La présence de la règle (de préférence linéaire) permet ainsi de déterminer à tout moment le positionnement, la vitesse, l'accélération et/ou la décélération des chariots le long du chemin de transport (sur la boucle de transport). Dans un mode d'exécution préféré de la présente invention, le chariot intègre au moins un lecteur (de préférence un lecteur optique) qui constitue la partie mobile du capteur de déplacement.

La figure 1 illustre de manière schématique une vue d'ensemble du dispositif de transport de substrats selon la présente invention. On peut y apercevoir le convoyeur de substrats de type carrousel permettant de guider et déplacer les substrats, le dit convoyeur comprenant un rail fixe qui forme une boucle de transport fermée, et des chariots qui maintiennent les substrats dans une position immobile (par exemple à plat) et qui se déplacent sur le dit rail en transportant les substrats, le contrôle du déplacement étant permis grâce à la règle linéaire qui, sur cette figure 1, est confondue avec le rail fixe. La figure 6 illustre également de manière schématique la règle qui est positionnée dans cette configuration à gauche de la pièce de maintien optionnelle qui est fixée sur le rail fixe.

Dans un mode d'exécution préféré de la présente invention, le dispositif de transport est équipé d'au moins un capteur de déplacement, de préférence un capteur de déplacement linéaire, pour mesurer le déplacement (position, vitesse, accélération et/ou décélération) du chariot par rapport au(x) poste(s) de traitement. Tout capteur de déplacement satisfaisant les exigences de précision requises pourra avantageusement être utilisé dans le dispositif selon la présente invention. On citera à titre illustratif et non limitatif un capteur de déplacement comportant une partie mobile et une partie fixe, par exemple une règle magnétique. Dans un mode d'exécution préféré de la présente invention, la partie mobile du capteur (« mobile » car elle se déplace avec le chariot) de déplacement (par exemple du capteur magnétique) consiste de préférence en une règle linéaire fixée selon un axe longitudinal (c'est-à-dire parallèle au sens de déplacement du chariot) sur le chariot (ou faisant partie intégrante du chariot). La présence de la règle, de préférence linéaire, permet ainsi de déterminer à tout moment le positionnement, la vitesse, l'accélération et/ou la décélération des chariots le long du chemin de transport (par exemple sur la boucle de transport) par rapport au(x) poste(s) de traitement. Dans un mode d'exécution préféré de la présente invention, au moins un poste de traitement, de préférence au moins un poste d'impression, de préférence tous les postes d'impression, voir même tous les postes de traitement, intègrent au moins un lecteur (de préférence un lecteur magnétique) qui constitue la partie fixe du capteur de déplacement.

Dans un mode d'exécution préféré de la présente invention, le dispositif de transport est équipé d'au moins un capteur « O » de déplacement pour mesurer le déplacement du chariot par rapport au chemin de transport (par exemple le rail) et d'au moins capteur « M » de déplacement pour mesurer le déplacement du chariot par rapport au poste de traitement. Dans un mode d'exécution particulier de la présente invention, le lecteur du capteur « O » et la règle du capteur « M » se trouvent sur le chariot. Dans un mode d'exécution particulier de la présente invention, la règle du capteur « O » fait partie intégrante du rail et/ou est fixée sur le rail et/ou est fixée sur le socle du rail et/ou fait partie intégrante du socle du rail et/ou est fixée sur la structure du rail et/ou fait partie intégrante de la structure du rail. Dans un mode d'exécution particulier de la présente invention, le lecteur du capteur « M » est fixé sur un élément fixe (ou mobile) d'un poste d'impression et/ou d'un poste de séchage et/ou d'un autre poste de traitement. Dans un mode d'exécution particulier de la présente invention, le capteur « O » est un capteur de déplacement linéaire optique et le capteur « M » est un capteur de déplacement linéaire magnétique. En effet, la Demanderesse a découvert, grâce à la combinaison de ces deux capteurs de déplacements, qu'on pouvait atteindre un niveau de précision de mesure exceptionnel (par exemple de l'ordre du micromètre sur les sections critiques de la boucle de transport, par exemple de l'ordre du micromètre sur des longueurs de boucle de transport de l'ordre du mètre) permettant ainsi une gestion optimisée de la gestion du positionnement et/ou de la vitesse et/ou de l'accélération et/ou de la décélération des chariots le long du chemin de transport, par exemple le long de la boucle de transport. La double gestion de positionnement des lecteurs/capteurs telle que décrite ci-dessus apporte également d'autres avantages essentiels à la présente invention tels que décrits ci-après. En effet, le fait de disposer le lecteur du capteur « O » sur le chariot permet d'éviter tout problème de transmission de l'information mesurée entre le lecteur et les éléments actifs du chariot, par exemple le contrôle de l'ensemble primaire moteur de la motorisation linéaire du chariot mobile ; cette réactivité de contrôle permet d'améliorer le caractère intelligent et/ou autonome du chariot car elle permet de minimiser les délais entre la mesure et l'action induite correspondante. De plus, le fait de disposer la règle du capteur « M » sur le chariot et donc le lecteur correspondant du capteur « M » sur un élément fixe (ou mobile) d'un poste de traitement (par exemple d'un poste d'impression et/ou d'un poste de séchage et/ou d'un autre poste de traitement) permet d'éviter tout problème de transmission de l'information mesurée entre le lecteur et les éléments actifs du poste de traitement (par exemple d'un poste d'impression (par exemple les têtes d'impression du dit poste d'impression) et/ou de séchage et/ou d'autre traitement) le long du chemin de transport. Cette réactivité permet au(x) dit(s) poste(s) d'agir sans retard en fonction de la mesure prise car elle permet de minimiser les délais entre la mesure et l'action induite correspondante ; cette réactivité permet également d'éviter d'avoir un système d'échange d'information entre le chariot et le poste de traitement pour obtenir cette information de positionnement, ce qui réduit par ailleurs les coûts. De plus, la double gestion de positionnement permet d'ajuster les éléments de mesures au(x) besoin(s) du/des chariot(s) et du/des poste(s) de traitement (par exemple, un poste d'impression). En effet, la Demanderesse a constaté que la précision de mesure, et plus particulièrement la connaissance du positionnement de la partie mobile (par exemple, le chariot), peut être différente entre le(s) chariot(s) et le(s) postes de traitement. Ainsi, la précision de mesure entre capteur « O » et capteur « M » peut être différente (inférieure ou supérieure) ou égale. Dans un cas particulier de l'invention, les capteurs peuvent être choisis en fonction du besoin du poste de traitement (ou du chariot) et peuvent donc être différents d'un poste de travail (ou chariot) à l'autre. Ceci permet aussi une réduction de coûts. En effet, comme il est possible d'ajuster le système de mesure aux besoins du/des chariot(s) et du/des poste(s) de traitement, le coût des pièces nécessaires est optimisé.

Dans un mode d'exécution préféré de la présente invention, le dispositif de transport comprend également au moins une glissière, par exemple une glissière disposée de chaque côté du rail fixe qui est de préférence central.

Les figures 2, 6 et 7 illustrent de manière schématique les composants de ces glissières de guidage qui, dans cette illustration et ce mode d'exécution, sont constituées de rails et des éléments de guidage (par exemple des patins de guidage) fixés au chariot; dans les figures 2 et 6, les rails des deux glissières sont fixés sur le socle et situés de part et d'autre du rail fixe ; dans la figure 7, les patins des glissières sont disposés sous la base du chariot et ils entourent les roues en V du système de guidage. Pour rappel, une variante de la figure 7 (non illustrée) sera de disposer les roues en V de telle sorte qu'elles entourent les patins des glissières, ce qui impliquera de préférence que les rails des glissières seront positionnés sur le rail fixe et que la hauteur des patins des glissières sera inférieure à celle des roues en V sous la base du chariot ; dans cette configuration, l'utilisation d'un seul rail pour la glissière est envisageable même si cela ne constitue pas une variante préférée selon la présente invention.

Tout type de glissière pourra avantageusement être utilisé selon la présente invention.

Dans un mode d'exécution préféré de la présente invention, la glissière comprend un rail, de préférence deux rails situés de chaque côté du rail (de préférence central), qui sont soit fixés sur le socle ou font partie intégrante du dit socle.

Dans une variante de réalisation selon la présente invention, la glissière comprend un rail, de préférence deux rails qui soit font partie intégrante du rail fixe (de préférence central) et/ou sont fixés sur le rail fixe (de préférence central) et/ou sont fixés sur le socle du rail fixe (de préférence central) et/ou font partie intégrante du socle du rail fixe (de préférence central) et/ou sont fixés sur la structure du rail fixe (de préférence central) et/ou faire partie intégrante de la structure du rail fixe (de préférence central).

Dans un mode d'exécution préféré de la présente invention, la glissière est lisse et comprend de préférence sur le chariot un ou plusieurs éléments (par exemple des éléments « femelles ») de guidage, de préférence au moins deux, par exemple au moins 4 (comme illustré dans la figure 7), par exemple des patins glissants.

Dans un mode d'exécution préféré de la présente invention, la glissière est une glissière en queue d'aronde.

En fait, sans vouloir être limité par cette explication, la Demanderesse pense que l'utilisation du rail central et son guidage en combinaison avec la glissière susmentionnée permet non seulement de satisfaire aux exigences de déplacement précis du chariot le long du chemin de transport (par exemple de la boucle de transport) mais également de permettre un déplacement optimisé lors des courbes du chemin de transport (de la boucle de transport).

Selon une variante de réalisation de la présente invention, la longueur du(des) rail(s) de(s) glissière(s) peut être identique à la longueur du rail fixe ou du chemin de transport (de la boucle de transport). Toutefois, et ceci constitue un mode d'exécution préféré selon la présente invention, la longueur totale de ce(s) rail(s) de glissière(s) sera de préférence inférieure à celle du rail fixe car on préfèrera ne pas en mettre dans les courbes/virages formés par le chemin de transport (la boucle de transport) ; on parlera de longueur totale de rail par glissière, car ledit rail d'une glissière pourra en fait être constitué de plusieurs morceaux de rails le long du chemin (de la boucle) de transport.

Dans un mode d'exécution préféré de la présente invention, la longueur totale du rail d'une glissière du dispositif de transport est sélectionnée de manière à couvrir tout l'espace situé en-dessous des postes d'impression du chemin (de la boucle) de transport. Plus particulièrement, si la valeur de la longueur totale des postes d'impression est X, la longueur totale du rail d'une glissière du dispositif de transport sera d'au moins X, de manière à garantir la planéité recherchée sous les postes d'impression et les exigences de déplacement précis du chariot le long de la boucle de transport. Toutefois, comme la présence de ce rail de glissière n'est pas indispensable en dehors des postes d'impression, la longueur totale du rail d'une glissière du dispositif de transport sera par exemple limitée à des valeurs inférieures à 3 fois X, de préférence inférieures à 2 fois X, par exemple inférieure à 1,5 fois X, voir inférieure à 1,2 fois X.

Dans une variante de réalisation selon la présente invention, la longueur totale du rail d'une glissière du dispositif de transport est inférieure à la somme des longueurs des parties linéaires du chemin de transport (par exemple de la boucle de transport), par exemple inférieure à la moitié de la longueur du chemin de transport et/ou de la boucle de transport, inférieure à 0,4 fois la longueur du chemin de transport et/ou de la boucle de transport, par exemple inférieure au tiers de la longueur du chemin de transport et/ou de la boucle de transport.

Dans une variante de réalisation selon la présente invention (ou dans le cas particulier lorsque la longueur totale du rail d'une glissière du dispositif de transport est inférieure à la longueur de la boucle de transport (et/ou lorsque le dit rail est composé de plusieurs parties de rails le long de la boucle de transport)), la largeur de l'extrémité initiale (l'entrée dans le sens du déplacement du chariot) et/ou la largeur de l'extrémité finale (la sortie dans le sens du déplacement du chariot) du dit rail seront avantageusement inférieure à la largeur moyenne du dit rail ; sans vouloir être limité par cette explication, la Demanderesse pense que cela permet d'assurer une insertion (et/ou une sortie) optimale de l'élément de guidage (par exemple du/des patins) dans le rail tout en limitant les usures mécaniques, une dégradation prématurée des rails ainsi que des phénomènes de vibration pouvant interférer avec les objectifs de la présente invention. On citera à titre illustratif une entrée en forme de V et/ou une sortie en forme de V inversé pour le rail d'une glissière du dispositif de transport.

Selon une variante préférée de réalisation de la présente invention, le système de guidage du chariot sur le rail fixe comprend
- au moins un couple d'éléments de guidage disposés de part et d'autre du rail (par exemple des roues), chaque couple d'éléments de guidage (par exemple couple de roues) comprenant un mécanisme assurant le guidage du chariot à la fois dans les lignes droites et dans les virages, par exemple une barre de maintien qui relie les deux éléments de guidage entre eux (par exemple les deux roues entre elles), la dite barre de maintien comprenant un axe pivotant relié au chariot permettant d'assurer un guidage optimal du chariot le long du rail et, en particulier le long des virages formés par le chemin de transport (par exemple la boucle de transport), et
- au moins une glissière constituée de rail(s) fixe(s) et des éléments de guidage tels que décrits ci-dessus, les dits éléments formant avec le(s) rail(s) une liaison glissière (par exemple des patins).

Une caractéristique d'un mode d'exécution de la présente invention est donc l'utilisation d'un convoyeur de substrats de préférence de type carrousel permettant de guider et déplacer les substrats au travers des postes de traitement, le dit convoyeur comprenant au moins un, de préférence plusieurs chariots qui maintiennent les substrats dans une position immobile (par exemple à plat) et qui se déplacent le long du chemin de transport (par exemple sur un rail fixe ce qui permet de mouvoir chaque ensemble chariot/substrat sur le rail) et étant caractérisé en ce que le dit chariot comprend une table, de préférence une table aspirante, de maintien du substrat dans une position immobile (par exemple à plat) par rapport à la table le long de la boucle de transport pendant les traitements du substrat. La figure 7 représente de manière illustrative le chariot et certains de ses composants, par exemple, une table de maintien des substrats, les roues en V du système de guidage ainsi que les patins des glissières, un élément de contact (électrique) glissant. Les dimensions des chariots et des tables seront sélectionnées en fonction des besoins et des applications tout en tenant compte des facteurs d'encombrement, de poids et d'usinage. A titre illustratif et non limitatif, nous avons conçu des chariots de dimensions (l/L/H) en mm de 800/1250/3000 comprenant des tables (de maintien) de dimensions (1/L/H) en mm de 765/1075/1500.

Dans une variante de réalisation de la présente invention, le chariot est équipé d'un moyen d'identification permettant la "personnalisation" lors du passage du chariot ainsi identifié au travers de n'importe quel poste du dispositif selon la présente invention. La présente invention pourra utiliser n'importe quelle technologie d'identification, de préférence sans contact, des chariots.

A titre illustratif et non limitatif, ce moyen d'identification pourra avantageusement être sélectionné parmi les technologies RFID (Radio Frequency Identification - technologie d'identification d'objets permettant de mémoriser et récupérer des données à distance en utilisant des marqueurs appelés « radio-étiquettes » (ou « tag » ou « transpondeur »), les code-barres, et/ou toute autre technologie basée sur un principe de reconnaissance, par exemple un émetteur / récepteur optique.

A titre illustratif et non limitatif, on pourra identifier le chariot de maintenance (par exemple le chariot de "nettoyage de tête jet d'encre" inséré dans le flot des chariots mobiles) et éviter ainsi qu'il ne soit soumis à un quelconque traitement concernant les substrats et ceci, comprenant également l'absence de chargement et/ou de déchargement de substrat sur ce chariot de maintenance.

Une caractéristique essentielle de la présente invention est donc que le dispositif de maintien/transport de substrats (dans une machine d'impression comprenant un ou plusieurs postes de traitement dont au moins un poste d'impression) comprend une table de maintien du substrat dans une position immobile par rapport à la table pendant le(s) traitement(s) du substrat, et caractérisé en ce que la table de maintien comprend une couche structurelle à nid d'abeille. Selon une variante de réalisation de la présente invention, tout type de table de surface supérieure de préférence plane et tout système de maintien du substrat dans une position immobile (par exemple à plat) sur la dite table pourront avantageusement être utilisés pour autant que la dite table comprenne une couche structurelle à nid d'abeille. Ainsi, selon un mode d'exécution particulier de la présente invention, la force de maintien exercée par le système de maintien en position immobile du dit substrat sur la table sera supérieure à toute autre force qui pourrait provoquer le déplacement du substrat lors des traitements du dit substrat et/ou lors des déplacements du chariot. A titre illustratif de système de maintien du substrat dans une position immobile (par exemple à plat) sur la table, nous citerons des moyens de préhension ou de pression du substrat, par exemple des pinces et/ou des réglettes de pincement. Afin de répondre aux objectifs particuliers de la présente invention, les dimensions de la table répondront donc de préférence aux critères suivants : une dimension transversale (c'est-à-dire perpendiculaire à l'axe longitudinal dans le plan du chemin de transport) au moins équivalente à la grandeur transversale du substrat le plus grand utilisé - et une dimension longitudinale au moins équivalente à la dimension longitudinale du substrat le plus grand utilisé ; un avantage additionnel de la présente invention est que plusieurs substrats (identiques ou différents) peuvent être maintenus dans une position immobile (par exemple à plat) sur la table ce qui démontre la flexibilité exceptionnelle qu'apporte le dispositif selon la présente invention. La couche supérieure du chariot illustré dans la figure 7 est une représentation schématique simplifiée de toute la table de maintien (vue de face). Une représentation de trois substrats identiques maintenus en position immobile sur une table de maintien est décrite à titre illustratif dans la figure 8 (vue du dessus).

Une caractéristique d'un mode particulier et préféré d'exécution de la présente invention est donc l'utilisation comme table de maintien d'une table aspirante (qui fait de préférence partie du chariot de transport) et qui permet de maintenir les substrats dans une position immobile (par exemple à plat), par exemple le long du chemin de transport (de préférence le long de la boucle de transport). Les tables aspirantes et leur fonctionnement sont bien connus par l'homme du métier et ce dernier pourra donc facilement utiliser une table aspirante appropriée à la présente invention. La constitution et les dimensions de la table aspirante ne sont pas critiques pour autant qu'elle remplisse bien son rôle de maintien dans une position immobile (par exemple à plat) du substrat. Ainsi, selon un mode d'exécution particulier de la présente invention, la force de maintien en position immobile du dit substrat sur la table aspirante sera supérieure à toute autre force qui pourrait provoquer le déplacement du substrat lors des traitements du dit substrat et/ou lors des déplacements du chariot; on citera à titre illustratif et non limitatif le cas de l'influence que pourrait avoir un séchage à courant d'air chauffé sur la position du substrat sur la table aspirante, influence qui doit donc être annihilée grâce à la force de maintien de la table aspirante.

La partie supérieure des tables aspirantes est généralement appelée la sole aspirante, sole qui est habituellement faite majoritairement de métal et/ou de polytétrafluoroéthylène (aussi connu sous le nom de Téflon) percée de multitudes de trous permettant à la table d'exercer l'aspiration et donc le maintien grâce à cette force d'aspiration du substrat sur la sole. Dans un mode d'exécution préféré de la présente invention, une sole du type décrit ci-dessus n'est pas utilisée comme illustré ci-dessous dans la description des figures.

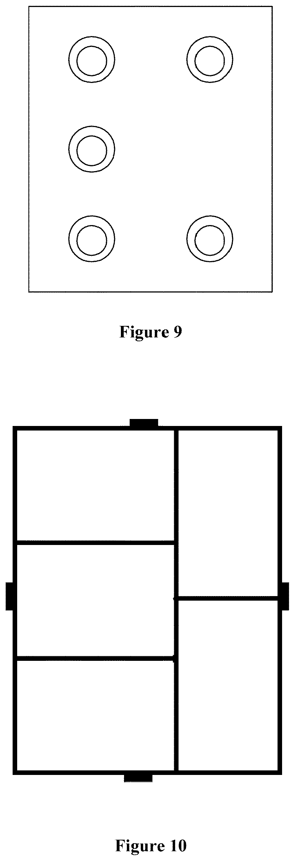

La partie inférieure des tables aspirantes est généralement constituée d'une zone d'aspiration active (ensemble d'aspiration active). Les tables aspirantes et leur fonctionnement sont bien connus par l'homme du métier et ce dernier pourra donc facilement utiliser une table aspirante comprenant une zone d'aspiration active appropriée à la présente invention, à savoir une zone d'aspiration active suffisamment puissante pour pouvoir maintenir le substrat dans une position immobile (par exemple à plat) sur la table aspirante. A titre illustratif, une zone active d'aspiration active est représentée dans la figure 9 ou on peut apercevoir que la zone d'aspiration active comprend cinq aspirations (représentées dans la figure par des ventilateurs) qui sont de préférence réglables individuellement. Pour rappel, il a déjà été précisé qu'un objectif majeur de la présente invention est d'éviter que les composants du dispositif de transport n'interfèrent avec les exigences d'efficacités de chacun des postes d'impressions et/ou de traitements. Il en va bien évidemment de même pour la table aspirante et on privilégiera dans le cadre de la présente invention un contrôle (par exemple par variation de la puissance d'aspiration), de préférence un contrôle individuel, des éléments d'aspirations constitutifs de la zone d'aspiration active (de l'ensemble d'aspiration active). Afin de faciliter la compréhension de la présente description et des revendications, nous caractériserons l'ensemble d'aspiration active comprenant au moins deux éléments d'aspiration par le terme « compartimenté ». Ainsi, dans un mode d'exécution préféré selon la présente invention, l'ensemble d'aspiration active (la zone d'aspiration active) compartimenté comprendra au moins deux, de préférence au moins trois, de préférence au moins quatre, par exemple au moins cinq éléments d'aspiration dont la puissance est contrôlable, de préférence de manière individuelle. Une représentation de cinq éléments d'aspiration (5 ventilateurs) est décrite à titre illustratif dans la figure 9 (vue du dessous). L'ensemble constitué par la zone d'aspiration active est donc un composant essentiel de la table d'aspiration, le dit ensemble d'aspiration active constituant de préférence la couche inférieure de la table. Dans une variante de réalisation selon la présente invention, cet ensemble d'aspiration active sera attaché à la couche passive située directement au-dessus, par exemple au moyen de clips ; à titre illustratif, cet ensemble d'aspiration active pourra être intégré dans un cadre qui sera de préférence attaché à la couche passive située directement au-dessus, par exemple au moyen de clips. Dans une autre variante de réalisation selon la présente invention, cet ensemble d'aspiration active sera attaché à la base du chariot ou à un élément intermédiaire lui-même attaché à la base du chariot. Dans un mode d'exécution préféré selon la présente invention, l'aspiration s'effectue de manière à ce que la direction de l'écoulement de l'air au travers de l'ensemble d'aspiration active (la zone d'aspiration active) soit verticale.

Dans un mode d'exécution préféré selon la présente invention, la table aspirante comprend également une couche structurelle à chambres (zone d'aspiration passive/ensemble d'aspiration passive), située au-dessus de la zone active d'aspiration (entre la zone d'aspiration active et le substrat), qui aide à compartimenter les flux d'aspiration. Cette couche structurelle est de préférence rigide ou semi-rigide. Par exemple, cette couches structurelle comprend des chambres Ch (ou compartiments Ch), qui sont disposées de préférence en vis-à-vis des compartiments de la zone d'aspiration, afin d'améliorer le contrôle de la puissance et/ou de l'homogénéisation de l'aspiration au sein des chambres. Les dimensions de cette couche structurelle chambres (zone d'aspiration passive/ensemble d'aspiration passive) seront sélectionnées en fonction des besoins et des applications ; les largeurs/longueurs de cette couche structurelle (par exemple un cadre de forme parallélépipède rectangle de hauteur « h ») coïncideront de préférence avec celles de la couche d'aspiration active ; les hauteurs de cette couche (et donc, de préférence, également des chambres) ne sont pas critiques pour autant que la couche remplisse bien son rôle d'homogénéisation et/ou de contrôle de la puissance d'aspiration de la table aspirante ; à titre illustratif et non limitatif nous citerons une hauteur « h » de cette couche structurelle (et donc, de préférence, également des chambres) comprise entre 10 et 50 mm, par exemple entre 15 et 30 mm, par exemple de 20 mm. Cette couche structurelle comprendra avantageusement au moins deux, de préférence au moins trois, de préférence au moins quatre, par exemple au moins cinq chambres. Le nombre de chambres pourra avantageusement correspondre au nombre de compartiments de la zone d'aspiration active. Toutefois, et ceci constitue un mode d'exécution particulier selon la présente invention, la couche structurelle sera amovible (par exemple au moyen de clips) et pourra donc être remplacée en fonction des besoins ; ceci permettra d'utiliser un nombre de chambres approprié aux substrats et/ou aux traitements utilisés sans devoir changer la zone d'aspiration active compartimentée. Selon une variante de réalisation de la présente invention, le nombre de chambres restera inférieur à 20, de préférence inférieur à 10, de manière à éviter un encombrement susceptible d'interférer avec les performances de la zone d'aspiration.

A titre illustratif, une zone d'aspiration passive est représentée dans la figure 10 où on peut apercevoir que la zone d'aspiration passive comprend cinq chambres (représentées dans la figure par des rectangles - vue du dessus) ; des clips peuvent également être aperçus sur les quatre côté de ce cadre.

Dans un mode d'exécution préféré selon la présente invention, l'aspiration s'effectue de manière à ce que la direction de l'écoulement de l'air au travers de la zone d'aspiration passive (ensemble d'aspiration passive) soit verticale. Ainsi, selon un mode d'exécution préféré selon la présente invention, la table de maintien est une table aspirante qui comprend un ensemble d'aspiration active compartimenté en deux ou plusieurs éléments d'aspiration (par exemple 3, 4, 5, ou plus) surmontée par un ensemble d'aspiration passive compartimenté en deux ou plusieurs chambres (par exemple 3, 4, 5, ou plus), caractérisée en ce que, de préférence, le nombre et la disposition des chambres coïncident avec les éléments d'aspiration.

Selon une variante de réalisation de la présente invention, la surface de la partie supérieure des chambres sera constituée de grille(s) dont le rôle sera double : ces grilles permettront non seulement de conférer à la partie supérieure de l'ensemble d'aspiration passive une surface plane qui améliorera ainsi le positionnement à plat de la couche suivante et également aideront à bien répartir les flux d'aspiration au sein de chaque chambre. Ainsi, une chambre comprendra avantageusement à sa surface supérieure au moins cinq, de préférence au moins dix, par exemple au moins 15 sous-chambres de surface délimitées par les mailles de la grille. A titre illustratif, la figure 11 décrit une couche structurelle (zone d'aspiration passive/ensemble d'aspiration passive) qui comprend 5 chambres, 3 chambres comprenant chacune 24 sous-chambres de surface et 2 chambres comprenant chacune 18 sous-chambres de surface.

Dans un mode d'exécution préféré selon la présente invention, la couche structurelle à chambres (zone d'aspiration passive/ensemble d'aspiration passive) comprend également des éléments additionnels d'homogénéisation de l'aspiration, éléments préférablement situés aux endroits où le positionnement des ventilateurs risque de causer des pics et/ou tourbillons d'aspiration qui pourraient interférer avec le bon fonctionnement des postes de traitement. A titre illustratif, la figure 11 illustre une couche structurelle (zone d'aspiration passive/ensemble d'aspiration passive) qui comprend 5 éléments additionnels d'homogénéisation d'aspiration (sous la forme de pastilles) qui sont situés en vis-à-vis du centre des éléments d'aspiration de la zone d'aspiration active ce qui permet de pallier à tout effet de tourbillon et/ou de pic d'aspiration que pourraient générer les dits éléments d'aspiration.

Ainsi, selon un mode d'exécution particulier de la présente invention, la table aspirante comprend un ensemble d'aspiration active (zone d'aspiration active) tel que défini ci-dessus en combinaison avec un ensemble d'aspiration passive (zone d'aspiration passive) tel que défini ci-dessus de façon à contrôler la puissance d'aspiration de la table en fonction du positionnement des substrats ; à titre illustratif, ceci permet non seulement d'équilibrer au mieux l'aspiration quelle que soit la position et la taille des substrats mais également d'être en mesure de limiter l'aspiration dans des zones spécifiques délicates comme lors du passage du chariot en-dessous des têtes d'impression.

Dans un mode d'exécution particulier selon la présente invention, un système permettant de varier la hauteur et/ou l'orientation et/ou une translations/rotation de la table de maintien (de préférence la table aspirante) est intégré dispositif, de préférence intégré au chariot, par exemple un système de motorisation et/ou de vérin(s). Ce système (par exemple cette motorisation et/ou ces vérins) additionnel peut s'avérer extrêmement utile par exemple, pour compenser des buses d'impression défaillantes et/ou pour augmenter la résolution des impressions et/ou pour garantir un positionnement optimal des substrats sous les postes de traitement. A titre illustratif et non limitatif, on citera une rotation et/ou une translation de la table permettant l'utilisation d'une buse en remplacement d'une buse défaillante pour la réalisation de l'impression à un endroit précis du substrat. A titre illustratif et non limitatif, on utilisera une motorisation (transversale) micrométrique pour ce type de motorisation ; les déplacements pourront donc avantageusement atteindre une précision de l'ordre du micron et seront de préférence restreints à des valeurs maximales équivalentes au cm dans les trois dimensions de l'espace.

A titre illustratif et non limitatif, la figure 7 illustre la présence de cet élément comprenant une motorisation additionnelle ; on peut en effet y apercevoir un chariot comprenant, une base structurelle représentée en gris clair sur la figure surmontée d'une table de maintien (en gris foncé) et également une pièce intermédiaire entre la table et la base constituant cet élément de motorisation additionnelle, par exemple une motorisation micrométrique permettant le déplacement de la table dans une direction perpendiculaire au sens de déplacement du chariot.

Dans un mode d'exécution particulier de la présente invention, la table (de préférence la table aspirante) comprend une couche structurelle consistant en un treillis de maintien des substrats. A titre illustratif et non limitatif, ce treillis peut avantageusement être utilisé pour des substrats de faible grammage ; ce qui permet d'éviter tout « marquage » éventuel des dits substrats lors de leur immobilisation sur la table. En fait, sans vouloir être limité par cette explication, la Demanderesse pense que l'utilisation d'un treillis de maintien des substrats permet également de figer et maintenir la couche nid d'abeille dans sa forme originelle tout en, dans la variante d'utilisation de table aspirante, garantissant et améliorant l'homogénéisation de l'aspiration.

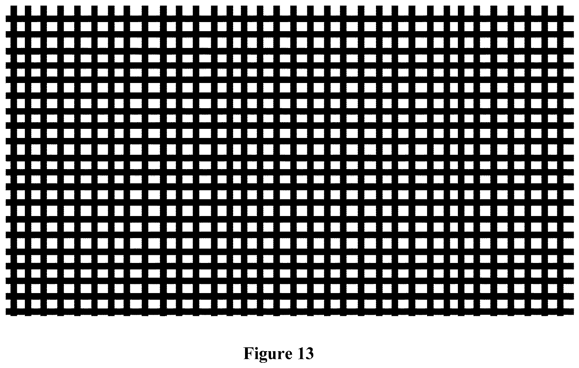

A titre illustratif et non limitatif, un treillis de maintien est illustré dans la figure 13.

A titre illustratif et non limitatif, une grille en inox et/ou en fibre céramique pourra avantageusement être utilisée comme treillis. Il est évident que l'homme de l'art saura sélectionner d'autres matériaux, similaires ou non à l'inox et/ou aux fibres céramiques, qui répondront également aux exigences de la présente invention.

A titre illustratif et non limitatif, le maillage du treillis sera sélectionné parmi les maillages fins pour éviter un texturale du papier imprimé.

A titre illustratif et non limitatif, les dimensions d'une maille du treillis seront inférieures à la moitié de la taille de la cellule du nid d'abeille, par exemple inférieures au quart de la taille de la cellule du nid d'abeille.

A titre illustratif et non limitatif, le treillis a
- une épaisseur comprise entre 1 micron et 1 mm, de préférence entre 10 et 500 microns, par exemple entre 25 et 300 microns ; et/ou
- un réseau à maille (carrée, rectangle, triangulaire, hexagonale ou autre) dont la longueur la plus grande d'un côté de la maille est comprise entre 1 micron et 1 mm, de préférence entre 50 et 500 microns, par exemple entre 75 et 300 microns ; et/ou
- un diamètre de fil compris entre 1 micron et 1 mm, de préférence entre 10 et 200 microns, par exemple entre 25 et 150 microns.

Les dimensions de surface de la couche structurelle treillis seront sélectionnées en fonction des besoins et des applications et correspondront de préférence à la surface du substrat (ou des substrats s'il y en a plusieurs maintenus sur la même table) augmentée d'une marge de sécurité ; nous citerons à titre illustratif des dimensions (l/L) en mm de l'ordre de 760/1070. Les largeurs/longueurs de ce treillis coïncideront de préférence avec celles de la couche structurelle à nid d'abeille, et optionnellement avec celles de la couche d'aspiration passive, et optionnellement également avec celles de la couche d'aspiration active.

Le treillis sera de préférence constitué d'un réseau de mailles régulières et/ou identiques.

La combinaison d'un treillis tel que défini ci-dessus fixé sur la couche structurelle de type nid d'abeille (comme décrite ci-dessus) constitue un mode d'exécution préféré selon la présente invention en matière de maintien des substrats sur la table (de préférence la table aspirante). En effet, l'utilisation d'une couche structurelle de type nid d'abeille (comme décrite ci-dessus) et du treillis permet de s'affranchir des soles aspirantes de l'art antérieur telles que par exemple celles décrites ci-dessus (soles habituellement faites majoritairement de métal et/ou de polytétrafluoroéthylène (aussi connu sous le nom de Téflon) et percées de multitudes de trous) ; en effet, la couche structurelle de type nid d'abeille (comme décrite ci-dessus) sur laquelle est déposé/fixé un treillis peut directement servir de sole de maintien pour les substrats et permettre ainsi à la table d'exercer l'aspiration et donc le maintien des dits substrats sur cette sole.

Dans un mode d'exécution particulier de la présente invention, le treillis est fixé de manière amovible sur la table ce qui permet de le remplacer et/ou le changer en fonction, par exemple, des types de substrats utilisés. Tout système de fixation amovible pourra avantageusement être utilisé ; nous citerons à titre illustratif une fixation de type grenouillère et/ou de type clipsable. Dans une variante de réalisation le système de fixation amovible fixe le treillis directement sur la couche nid d'abeille.

Selon une variante de réalisation de la présente invention, des zones de masquage optionnelles peuvent être ajoutées au treillis, par exemple pour empêcher que l'aspiration ne s'effectue dans des zones sans substrat.

Dans un mode d'exécution particulier de la présente invention, la table (de préférence la table aspirante) comprend une couche optionnelle additionnelle consistant en un filtre qui permet d'améliorer encore l'efficacité de la table en permettant de piéger les rayonnements en évitant qu'ils ne se réfléchissent sur la table. A titre illustratif et non limitatif, ce filtre est un filtre anti-UV.

Les dimensions de surface de la couche filtre seront sélectionnées en fonction des besoins et des applications et correspondront de préférence à la surface du substrat (ou des substrats s'il y en a plusieurs maintenus sur la même table) augmentée d'une marge de sécurité ; nous citerons à titre illustratif des dimensions (l/L) en mm de l'ordre de 760/1070. Les largeurs/longueurs de ce filtre coïncideront de préférence avec celles du treillis et/ou de la couche structurelle à nid d'abeille, et optionnellement avec celles de la couche d'aspiration passive, et optionnellement également avec celles de la couche d'aspiration active.

Dans une variante de réalisation selon la présente invention, cette couche filtre sera placée directement en-dessous et/ou au-dessus de la couche à nid d'abeille et/ou du treillis.

Il peut arriver que des écarts de hauteur apparaissent entre certains points de la surface des couches susmentionnées dans la table, les dits écarts générant ainsi des différences de hauteur pouvant atteindre à certains endroits un ordre de grandeur de dizaine(s), voire de centaine(s) de microns. Il est préférable d'éviter que ces écarts n'impactent la qualité et/ou le rendement des postes de traitement (en particulier des postes d'impression). De plus, en cas d'écarts importants, il peut y avoir un risque de contact entre certains points de la couche supérieure de la table et le poste de traitement, par exemple les têtes d'impression qui risqueraient ainsi d'être endommagées.

Ainsi, dans un mode d'exécution particulier de la présente invention, la table (de préférence la table aspirante) comprend des éléments additionnels optionnels (que nous appellerons éléments de sous-couche de planéité) disposés en des endroits précis entre deux des couches sus mentionnées permettant l'amélioration de l'homogénéité/planéité de la table supportant le(s) substrat(s).

Cette sous-couche supplémentaire optionnelle permettra ainsi de niveler les couches situées au-dessus et/ou en-dessous de celle-ci et de rendre la dernière couche de la table bien plane.

A titre illustratif et non limitatif, cette sous-couche de planéité comprendra des plaques de métal (par exemple en aluminium) qui pourront à titre illustratif être disposées :
- soit entre l'ensemble d'aspiration active et l'ensemble d'aspiration passive (couche structurelle à chambres),
- soit entre l'ensemble d'aspiration passive (couche structurelle à chambres) et la couche nid d'abeille.

La figure 7 illustre donc une variante de chariot selon la présente invention, le dit chariot comprenant, une base structurelle représentée en gris clair sur la figure surmontée d'une table (en gris foncé) de support des substrats, des roues en V sous la base (pour le guidage en V - rail fixe) et des patins des glissières ; cette figure 7 illustre également de manière schématique un élément de contact conducteur (contact électrique glissant) qui assure la liaison électrique entre le rail de courant (décrit ci-après) et le chariot.

De manière récapitulative et non nécessairement illustrée dans les figures, le chariot selon la présente invention comprend avantageusement une table de maintien comprenant une couche structurelle à nid d'abeille, et
- un cadre de structure, de préférence en aluminium, le dit cadre pouvant faire office de base du chariot, et/ou
- un élément du système de guidage, par exemple un élément du système de guidage en V (par exemple les roues en V), et/ou
- un élément de(s) glissière(s), par exemple l'élément glissant (par exemple le(s) patin(s)), et/ou
- un élément de commande du chariot, par exemple un automate programmable, et/ou
- un système de motorisation permettant d'orienter la table dans les 3 dimensions de l'espace, et/ou
- une table aspirante, et/ou
- un ensemble d'aspiration active, et/ou
- un ensemble d'aspiration passive, et/ou
- un treillis, et/ou
- une couche filtre, et/ou
- une sous-couche de planéité, et/ou
- des éléments des capteurs de déplacement, et/ou
- des éléments de protection des chariots tels que décrits ci-après.

Dans un mode d'exécution particulier de la présente invention, le chariot comprendra également un dispositif de soulèvement des substrats. En effet, dans certaines situations et, en particulier dans le domaine de l'impression pour l'électronique imprimée, il est nécessaire d'utiliser un système particulier d'alimentation et d'enlèvement des substrats à traiter, le dit système rendant nécessaire l'intégration dans le chariot d'un dispositif autonome de soulèvement des substrats. Tout dispositif de soulèvement autonome pourra avantageusement être utilisé ; nous citerons à titre illustratif un dispositif comprenant des vérins disposés sur le chariot, par exemple disposés dans la table. Ainsi, ce dispositif permettra à la fois
- de réceptionner les substrats à traiter à une élévation suffisante au-dessus de la table lors de l'alimentation en substrat à traiter ; et
- de positionner à une élévation suffisante au-dessus de la table les dits substrats traités,
l'élévation étant dictée par le système particulier d'alimentation et d'enlèvement des substrats.

Dans un mode d'exécution particulier de la présente invention, la structure du chariot comprend au moins une protection qui permet d'éviter d'endommager les autres composants du chariot en cas de collision inopinée entre deux chariots. Cette protection sera donc idéalement placée sur le bord avant ou sur le bord arrière (dans le sens de défilement) du chariot ou, de préférence, sur les bords avant et arrière du chariot. Comme le dispositif selon la présente invention permet de contrôler de manière individuelle chacun des chariots et donc de connaitre précisément à tout instant leurs positions et leurs vitesses, ces protections ne sont pas indispensables. Toutefois, afin de pallier aux risques éventuels liés par exemple à une coupure de courant et/ou une défaillance en matière de transmission de données (instructions) au chariot, on privilégiera ce type de protection. Toute protection permettant de minimiser et/ou éliminer les problèmes que génèrerait un impact entre chariots pourra avantageusement être utilisée dans le cadre de la présente invention ; on citera à titre illustratif et non limitatif une protection amortissante de type pare-chocs soit à ressorts, soit à déformation.

Une caractéristique optionnelle du dispositif de transport de substrats de la présente invention est donc l'utilisation d'un convoyeur de substrats de type carrousel permettant de guider et déplacer les substrats au travers des postes de traitement, le dit convoyeur comprenant des chariots qui maintiennent les substrats dans une position immobile (par exemple à plat) et qui se déplacent sur un rail fixe qui forme une boucle de transport, caractérisé en ce que le dispositif comporte une voie de garage pour les chariots, la dite voie étant reliée de manière amovible au rail du convoyeur et permettant ainsi de parquer et/ou d'ajouter et/ou d'enlever un ou plusieurs chariots. A titre illustratif et non limitatif, ce type de voie de garage est similaire à ce qui est utilisé dans le domaine ferroviaire, avec un aiguillage permettant de dévier certains trains et/ou wagons. A titre illustratif et non limitatif, le chariot peut être amené par translation perpendiculaire à la boucle de transport vers la dite voie de garage par tout autre dispositif approprié. Cette voie de garage pourra avantageusement constituer une voie sans issue et/ou une boucle de dérivation sur la boucle de transport et se situer à tout endroit approprié de la boucle de transport, avec un point d'entrée et de sortie identique et/ou différents sur la boucle

Cette voie de garage est également très utile car elle permet d'effectuer tout acte de maintenance sur les chariots ; nous citerons à titre illustratif et non limitatif
- l'entretien et/ou le remplacement d'un ou plusieurs composants de la table tels que décrit ci-dessus, par exemple la protection et/ou le treillis et/ou la couche nid d'abeille et/ou un élément actif de l'aspiration (par exemple un ventilateur) ;
- l'entretien et/ou le remplacement d'un ou plusieurs composants de la partie active (ou de la partie passive en fonction de la configuration) de la motorisation linéaire ;
- l'entretien et/ou le remplacement d'un ou plusieurs composants des capteurs de déplacement ;
- l'ajout et/ou l'enlèvement de chariot(s) sur la boucle de transport.

Une caractéristique optionnelle du dispositif de transport de substrats de la présente invention est donc l'utilisation d'un convoyeur de substrats de type carrousel permettant de guider et déplacer les substrats au travers des postes de traitement, le dit convoyeur comprenant des chariots qui maintiennent les substrats dans une position immobile (par exemple à plat) et qui se déplacent sur un rail fixe qui forme une boucle de transport, caractérisé en ce que le dispositif comporte une voie de dérivation pour les chariots, la dite voie étant reliée de manière amovible au rail du convoyeur et permettant ainsi de prévoir tout type de traitement additionnel du substrat. A titre illustratif et non limitatif, nous citerons un processus de retournement du substrat sur la table et/ou un poste de revêtement souvent appelé poste de dorure (« foil »), comme décrit ci-avant dans la description ; notons toutefois que ces traitements et/ou processus pourraient également se dérouler sur la boucle de transport principale. Cette voie de dérivation pourra avantageusement constituer une boucle de dérivation sur la boucle de transport et se situer à tout endroit approprié de la boucle de transport, avec un point d'entrée et de sortie identique et/ou avantageusement différents sur la boucle ; par exemple, pour un processus de retournement de substrat une boucle de dérivation pourra être avantageusement disposée entre les postes de chargement et de déchargement des substrats.

Dans un mode d'exécution particulier de la présente invention, le dispositif de transport de substrats comprend au moins un chariot équipé d'un plateau de maintenance (par exemple un plateau de nettoyage et/ou un plateau de réglage). Ce chariot de maintenance (par exemple chariot « nettoyeur » et/ou « de réglage ») pourra avantageusement se trouver en mode repos sur une voie de garage telle que définie ci-dessus pour être ensuite amené en mode actif sur la boucle de transport de manière à effectuer tout acte de maintenance nécessaire au bon fonctionnement des postes de traitement. Ce chariot nettoyeur et/ou de réglage est très utile car il permet d'effectuer tout acte de maintenance sur les postes de traitement ; nous citerons à titre illustratif et non limitatif
- l'entretien et/ou le remplacement d'un ou plusieurs composants des postes de traitement, par exemple le nettoyage de buses d'impression, etc
- tout acte de réglage des composants des postes de traitement.

Dans un mode d'exécution particulier de la présente invention, le dispositif de transport de substrats comprend au moins un chariot équipé d'un plateau de diagnostic. Ce chariot de diagnostic pourra avantageusement se trouver en mode repos sur une voie de garage telle que définie ci-dessus pour être ensuite amené en mode actif sur la boucle de transport de manière à effectuer tout acte de diagnostic permettant de vérifier le bon fonctionnement des postes de traitement.

Nous citerons à titre illustratif et non limitatif une analyse des têtes d'impression.

Dans une variante de réalisation selon la présente invention, un chariot pourra comprendre à la fois un plateau de diagnostic et un plateau de maintenance.

Une caractéristique de la présente invention est donc l'utilisation d'un convoyeur de substrats (de préférence de type carrousel) permettant de guider et déplacer les substrats au travers des postes de traitement, le dit convoyeur comprenant des chariots qui maintiennent les substrats dans une position immobile (par exemple à plat) et qui se déplacent le long du chemin de transport (par exemple sur un rail fixe ce qui permet de mouvoir chaque ensemble chariot/substrat sur le rail).

La « partie gestion de la machine d'impression » est la partie du dispositif revendiqué (à l'exception du chariot) permettant la supervision et/ou le contrôle de différents éléments de la dite machine. A titre illustratif et non limitatif, la partie gestion de la machine d'impression peut comprendre la partie communication permettant d'échanger des informations entre les différents éléments de la machine et/ou avec les chariots. A titre illustratif et non limitatif, ces informations sont des ordres, des consignes, des positions, des vitesses, des identifications ou toute autre information utile d'être échangée entre les différents éléments de la machine et/ou avec les chariots. La partie gestion de la machine d'impression peut contenir les moyens de commande de différents actionneurs tels que les moyens de contrôle des postes de traitements. La partie gestion peut aussi contenir la gestion de différents capteurs (par exemple : capteur disposé sur la boucle de transport et/ou dans les postes de traitement, tel que le(s) capteur(s) de positionnement). La partie gestion peut comprendre la gestion des effecteurs. Un effecteur finalise le travail ; il produit l'effet attendu. La partie gestion peut aussi contenir des interfaces telles que des voyants, écran, moyen d'identification et tout autre moyen d'interfaçage. En effet, la Demanderesse ne souhaite pas se limiter aux interfaces Homme Machine. Il est tout à fait envisageable d'avoir une interface Machine Machine. A titre illustratif et non limitatif, une interface Machine Machine peut être un élément sur un poste de traitement (tel qu'un code barre) permettant aux chariots d'identifier ce poste de traitement et d'agir en conséquence. Bien sûr la Demanderesse ne souhaite pas être limitée uniquement à ces éléments cités précédemment. Il est évident pour l'Homme de métier que les automates programmables, circuits électroniques (pouvant contenir des FPGA, et/ou des microprocesseurs), etc ... peuvent être inclus dans la partie gestion de la machine d'impression.

Dans une variante de réalisation préférée selon la présente invention, le chariot de transport de substrat peut donc se déplacer de manière autonome le long du chemin de transport (de la boucle de transport) grâce à un élément moteur actif assurant son déplacement, par exemple, le moteur linéaire décrit ci-dessus (chariot intelligent et/ou autonome). Ce mode d'exécution implique la nécessité d'alimenter le chariot mobile en énergie et également d'assurer le transfert d'informations, de préférence le transfert bidirectionnel d'informations (de préférences d'informations numériques). Dans une variante de réalisation préférée selon la présente invention, cette alimentation sera permanente ; des périodes de veille seront toutefois tolérées lorsque le chariot est situé dans une zone où il peut rester immobile et/ou sans besoin en transfert d'informations.

La « partie gestion du chariot » est la partie du chariot permettant la supervision et/ou le contrôle de différents éléments du chariot. A titre illustratif et non limitatif, la partie gestion du chariot peut comprendre la partie communication permettant d'échanger des informations avec le reste de la machine. A titre illustratif et non limitatif, ces informations sont des ordres, des consignes, des positions, des vitesses, des identifications ou toute autre information utile d'être échangée entre le chariot et le reste de la machine. La partie gestion du chariot peut contenir les moyens de commande de différents actionneurs tels que les moyens de contrôle de l'ensemble primaire moteur. La partie gestion peut aussi contenir la gestion de différents capteurs (par exemple : capteur contenu dans le chariot tel que le(s) capteur(s) de positionnement). La partie gestion peut comprendre la gestion des effecteurs. Un effecteur finalise le travail ; il produit l'effet attendu. La partie gestion peut aussi contenir des interfaces telles que des voyants, écran, moyen d'identification et tout autre moyen d'interfaçage. En effet, la Demanderesse ne souhaite pas se limiter aux interfaces Homme Machine. Il est tout à fait envisageable d'avoir une interface Machine Machine. A titre illustratif et non limitatif, une interface Machine Machine peut être un élément sur le chariot (tel qu'un code barre) permettant aux autres postes de traitement d'identifier ce chariot et d'agir en conséquence. La partie gestion du chariot peut être considérée comme une partie du chariot permettant de rendre le chariot intelligent et/ou autonome. Bien sûr la Demanderesse ne souhaite pas être limitée uniquement à ces éléments cités précédemment. Il est évident pour l'Homme de métier que les automates programmables, circuits électroniques (pouvant contenir des FPGA, et/ou des microprocesseurs), etc ... peuvent être inclus dans la partie gestion du chariot. A titre illustratif et non limitatif, la partie gestion peut aussi comprendre les moyens de régulation d'énergie.

Toute solution d'alimentation en énergie du chariot mobile pourra avantageusement être utilisée dans le cadre de la présente invention. Dans une variante de réalisation préférée selon la présente invention, l'alimentation en énergie du chariot mobile (intelligent et/ou autonome) sera suffisante que pour fournir en électricité
- l'ensemble primaire moteur de la motorisation linéaire du chariot, et optionnellement
- la partie gestion du chariot, et/ou
- la table aspirante, et/ou
- le système de détection (ou capteur) de déplacement sur le chariot.

On citera à titre purement illustratif et non limitatif des alimentations de type batterie, pile, panneau solaire, générateur d'électricité (par exemple via essence), mouvement mécanique (par exemple, via des remontoirs à poids), mouvement automatique, et/ou dynamo, etc... Dans une variante de réalisation préférée selon la présente invention, l'alimentation en énergie du chariot mobile comprend un ensemble de rails conducteurs d'électricité qui sont de préférence fixes le long du chemin de transport et un élément de contact glissant qui est de préférence mobile et fixé sur le chariot. A titre illustratif et non limitatif, les figures 1 et 6 illustrent les dits rails conducteurs ; tout le long de la boucle de transport dans la figure 1 et sur la partie gauche de la figure 6, comme déjà décrit précédemment. Dans la figure 6, on peut apercevoir que le système d'alimentation en énergie est fixé sur la sole ; dans la figure 1, il est fixé sur toute la longueur de la sole et ensuite sur la structure porteuse du dispositif (allégé/évidé) de transport selon la présente invention. A titre illustratif et non limitatif, la figure 7 illustre sur la partie gauche de la figure une sorte de peigne correspondant à une représentation simplifiée de l'élément de contact glissant servant à alimenter en énergie le chariot.

Toute solution de transfert d'informations de/vers le chariot mobile pourra avantageusement être utilisée dans le cadre de la présente invention. Dans une variante de réalisation préférée selon la présente invention, un système à câble rayonnant est utilisé. A titre illustratif et non limitatif, la figure 6 illustre le câble rayonnant sur la partie gauche de la figure; dans cette illustration il est placé au-dessus des rails conducteurs.

Dans une variante de réalisation selon la présente invention, l'ensemble de rails conducteurs (par exemple de type « troisième rail ») assure la transmission (éventuellement bidirectionnelle) :
1. de l'énergie (électrique) alimentant l'élément moteur actif du chariot et des moyens de contrôle informatique du dispositif de transport ; et/ou
2. de signaux électriques de sécurité (arrêt d'urgence global et signaux d'erreur individuel de chaque chariot mobile) assurant l'arrêt de l'ensemble des chariots mobiles en cas de défaut, par exemple en cas de défaut d'un ou de plusieurs chariots et/ou en cas de défaut d'autres éléments du dispositif de transport et/ou de la machine d'impression ; et/ou
3. de signaux électriques permettant la synchronisation précise des chariots mobiles entre eux et/ou avec un moyen de contrôle informatique centralisé.

A titre illustratif, cette synchronisation précise peut être obtenue en utilisant :
- une horloge centralisée, et/ou
- des signaux de départ / arrêt de cycle centralisé.

A titre illustratif, cette synchronisation précise permet non seulement d'optimiser les temps de cycle de déplacements des chariots et donc de traitement des substrats ; mais elle permet également, dans certains modes de réalisation particuliers selon la présente invention, d'organiser des arrêts simultanés de deux chariots pour assurer respectivement leur chargement et déchargement de substrat(s).

Dans une variante de réalisation préférée selon la présente invention, l'alimentation en énergie du chariot mobile comprend donc au moins un élément de contact glissant fixé sur le chariot, le dit contact glissant sur l'ensemble de rails conducteurs décrits ci-dessus. A titre illustratif et non limitatif, la figure 7 illustre sur la partie gauche de la figure une sorte de peigne correspondant à une représentation simplifiée de l'élément de contact glissant servant à alimenter en énergie le chariot, le dit contact étant fixé à la structure du chariot. Dans une variante de réalisation préférée selon la présente invention, chaque chariot mobile est équipé de plusieurs contacts glissants sur l'ensemble de rails conducteurs, les dits contacts glissant formant un ensemble fixé sur chaque chariot.

Chaque chariot est ainsi alimenté et synchronisé en permanence tout au long du carrousel de transport sans avoir besoin d'être connecté au moyen de câbles à un système d'alimentation centralisé ce qui représente un avantage considérable du système d'alimentation du dispositif de transport selon la présente invention.

Ainsi, dans une variante de réalisation préférée selon la présente invention, le chariot de transport de substrat peut donc se déplacer de manière autonome le long du chemin de transport (de la boucle de transport) ce qui implique la nécessité d'assurer le transfert d'informations vers le chariot, de préférence le transfert bidirectionnel d'informations vers/depuis le chariot (de préférence d'informations numériques).

Comme déjà indiqué, toute solution de transfert, de préférence de transfert bidirectionnel, d'informations sans contact vers/depuis le chariot mobile pourra avantageusement être utilisée dans le cadre de la présente invention, comme par exemple un système à transmission radioélectrique de l'information comme illustré dans la figure 6, en particulier un câble rayonnant.

Dans une variante de réalisation préférée selon la présente invention, l'alimentation en information du chariot mobile est effectuée sans contact, par exemple grâce à l'utilisation du câble rayonnant susmentionné.

Dans un mode d'exécution préféré selon la présente invention, la Demanderesse a développé un système de communication sans contact pour le transfert, de préférence le transfert bidirectionnel, d'informations vers/depuis le chariot. A titre illustratif, nous citerons le choix d'ondes radioélectriques dont la transmission est assurée par une technologie sélectionnée parmi
- Le câble rayonnant, et/ou
- Le guide d'onde, et/ou
- Les antennes.

Dans un mode d'exécution préféré selon la présente invention, la solution privilégiée de communication sans contact pour transférer des informations vers et/ou depuis le chariot mobile comprend un câble rayonnant fixe le long du chemin de transport (de la boucle de transport) pour la transmission des ondes radioélectriques en communication avec au moins une antenne réceptrice des ondes radioélectriques placée sur chacun des chariots.

Ce type de communication sans contact permet à titre illustratif le paramétrage de cycle de déplacement des chariots, le dit paramétrage étant obtenu depuis un moyen informatique de contrôle.

A titre d'illustration, le moyen de communication choisi de ce paramétrage est une communication sans fil via un câble rayonnant électromagnétique placé tout le long du chemin de transport (par exemple du carrousel).

Toute technologie de transmission de l'information sans fil entre le chariot mobile et la partie fixe du dispositif selon la présente invention pourra avantageusement être utilisée. Nous citerons à titre illustratif la technologie LTE et/ou LTE-advanced (normes issues de la téléphonie mobile de générations actuelles (3G /4G) et futures, et/ou la technologie WiMAX (acronyme de Worldwide Interoperability for Microwave Access), et/ou la technologie Wi-Fi (abréviation de Wireless Fidelity), et/ou la technologie des femtocellules, et/ou la technologie sans fil Bluetooth, et/ou la technologie DECT (acronyme de Digital Enhanced Cordless Télécommunication).

Dans une variante de réalisation selon la présente invention, la transmission de l'information sans fil entre le chariot mobile et la partie fixe du dispositif selon la présente invention pourra avantageusement être effectuée au moyen de la technologie Li-Fi (« light fidelity »), en utilisant le principe de transmission de l'information par la lumière, par exemple en modulant la transmission de la lumière très rapidement ; tout type de lampes adaptées actuelles ou futures pourront avantageusement être utilisées (par exemple lampes LED).

Dans une variante de réalisation selon la présente invention, le transfert de l'information sans fil entre le chariot mobile et la partie fixe du dispositif selon la présente invention pourra également être effectué au moyen d'une technologie laser.

Dans une variante de réalisation selon la présente invention, la technologie de transfert (bidirectionnel) de l'information sans contact entre le chariot mobile et la partie fixe du dispositif de transport (par exemple le câble rayonnant) sera basée sur une solution dite « courte distance » de manière à prévenir les risques d'interférence avec l'environnement immédiat du dispositif de transport ; nous citerons à titre illustratif et non limitatif la technologie de communication en champ proche (CCP - aussi connue en anglais par Near Field Communication, NFC).

Dans un mode d'exécution préféré selon la présente invention, la solution privilégiée de communication sans contact pour transférer des informations depuis la boucle de transport vers les chariots comprend un moyen d'émission des informations qui est un élément fixe le long de la boucle de transport (par exemple un câble rayonnant) et, sur chaque chariot mobile, un moyen de réception des dites informations qui est un élément mobile fixé sur chacun des chariots (par exemple une antenne), élément de préférence couplé électro magnétiquement à l'élément fixe susmentionné le long de la boucle (de préférence un câble rayonnant). Cette solution présente l'intérêt :
- d'avoir un champ rayonnant limité à proximité du câble et donc de générer peu de perturbations électromagnétique, et/ou
- d'être immune aux perturbations électromagnétiques pouvant être générées par l'environnement extérieur et/ou générées par le chariot mobile lui-même du fait de l'utilisation possible de moyen de déplacement électromagnétique (moteur linéaire, etc.).

Dans un mode d'exécution préféré selon la présente invention, la communication des informations est bidirectionnelle. Dans cette variante, la solution privilégiée de communication bidirectionnelle comprend un moyen d'émission et de réception des informations qui est un élément fixe le long du chemin de transport / de la boucle de transport (par exemple un câble rayonnant) et, sur chaque chariot mobile, un moyen de réception et d'émission des informations (par exemple une antenne), élément de préférence couplé électro magnétiquement à l'élément fixe susmentionné le long du chemin / de la boucle (de préférence un câble rayonnant). Cette solution présente l'intérêt, en plus du paramétrage, de permettre la remontée d'informations de chacun des chariots mobiles vers le "moyen de contrôle" informatique du dispositif revendiqué, par exemple des informations relatives aux déplacements du chariot (vitesse, position, accélération, décélération) et/ou relatives à des statuts divers et variés (par exemple messages d'erreurs, informations provenant de capteurs, etc.). La transmission, de préférence bidirectionnelle, d'informations entre le moyen de contrôle (par exemple un ordinateur) et le moyen d'émission et de réception des informations du dispositif revendiqué (par exemple l'élément fixe le long du chemin / de la boucle de transport, de préférence le câble rayonnant) peut être filaire et/ou sans contact au moyen de l'une ou l'autre des technologies sans contact susmentionnées.

Dans une variante de réalisation préférée selon la présente invention, le dispositif revendiqué comprend également un ensemble de capteurs et de protections assurant la sécurité de déplacement des chariots mobiles, par exemple des capteurs de distance. On citera à titre illustratif la présence sur les chariots d'un capteur de distance pour détecter le chariot qui le précède le long du chemin de transport et/ou un capteur de distance pour détecter le chariot qui le suit le long du chemin de transport ; ainsi chaque chariot peut gérer de manière autonome sa position par rapport aux autres chariots et adapter ainsi sa position, et/ou sa vitesse, et/ou sa décélération et/ou son accélération.

Tout type de capteur de détection de position pourra avantageusement être utilisé dans le cadre de la présente invention ; à titre illustratif et non limitatif des capteurs laser seront privilégiés. L'utilisation des dits capteurs permettra à chaque chariot :
- d'être indépendant et de garantir ainsi son autonomie ;
- d'éviter d'entre en collision avec les chariots situés devant et/ou derrière et ainsi assurer le respect des opérations (accélération, vitesses continue, etc.)

Dans une variante d'exécution de la présente invention, chaque chariot comprend au moins un capteur de détection tel que décrit ci-dessus, le dit capteur étant positionné à tout endroit approprié sur le bord avant et/ou arrière du chariot (dans le sens de défilement du chariot), par exemple au centre du bord.

Dans une variante d'exécution particulière de la présente invention, chaque chariot comprend au moins un capteur de détection tel que décrit ci-dessus, le dit capteur étant positionné sur le bord avant et/ou arrière du chariot (dans le sens de défilement du chariot) et caractérisé en ce que sa position sur le bord du chariot est située à proximité du- et/ou sur-le coin extérieur du bord (le terme « extérieur » est utilisé par rapport à la rotation autour de la boucle) ; par exemple, pour un chariot dont le bord (avant ou arrière) est de longueur X, le capteur sera disposé sur le bord (avant ou arrière) à une distance du coin extérieur inférieure à X/2, inférieure à X/4, de préférence inférieur à X/8.

Dans une variante d'exécution préférée de la présente invention, chaque chariot comprendra au moins un capteur de détection tel que décrit ci-dessus sur le bord avant du chariot, et au moins un capteur de détection tel que décrit ci-dessus sur le bord arrière du chariot.

Dans une variante d'exécution de la présente invention, l'onde émise par le capteur positionné sur le bord avant/arrière d'un chariot forme tout angle approprié par rapport au dit bord avant/arrière du chariot, par exemple un angle de 90 degrés.

Dans une variante d'exécution particulière de la présente invention, l'onde émise par le capteur positionné sur le bord avant/arrière d'un chariot forme un angle par rapport au dit bord avant/arrière du chariot compris entre 30 et 90 degrés, par exemple inférieur à 90 degrés, entre 35 et 55 degrés, par exemple entre 40 et 50 degrés, par exemple de l'ordre de 45 degrés.

La présente invention concerne également l'utilisation du dispositif de maintien des substrats selon l'une quelconque des variantes de réalisation déjà décrites dans une machine d'impression comprenant au moins un poste d'impression, de préférence au moins deux postes d'impression différente sans contact en série (de préférence impression numérique à jet d'encre), et au moins un poste de séchage (par exemple le long du chemin de transport) ; et, en particulier, la dite utilisation dans une machine d'impression comprenant également un poste de revêtement (par exemple par dépôt d'un revêtement additionnel, par exemple de dorure ou d'autre matière) appliquant/pressant une feuille du dit revêtement sur des zones sélectionnées du substrat (par exemple comportant un dépôt d'adhésif selon un motif prédéterminé) de manière à faire adhérer aux zones sélectionnées la partie désirée de la feuille du dit revêtement.

La présente demande décrit diverses caractéristiques techniques et avantages en référence aux figures et/ou à divers modes de réalisation. L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles. De plus, les caractéristiques techniques décrites dans un mode de réalisation donné peuvent être isolées des autres caractéristiques de ce mode à moins que l'inverse ne soit explicitement mentionné.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus. L'invention est définie par les revendications.

## Revendications

1. Machine d'impression comprenant un dispositif de maintien de substrats et plusieurs postes de traitement dont au moins un poste d'impression sans contact et au moins un poste de séchage, le dit dispositif de maintien de substrats comprenant un chariot mobile comprenant une table de maintien du substrat dans une position immobile par rapport à la table pendant le(s) traitement(s) du substrat, **caractérisé en ce que** la table de maintien est une table aspirante
- qui comprend une couche structurelle à nid d'abeille et une couche structurelle optionnelle consistant en un treillis de maintien des substrats à maillage fin qui constituent la sole de maintien des substrats.

2. Machine d'impression selon la revendication précédente **caractérisé en ce que** la couche structurelle à nid d'abeille a une épaisseur « e » comprise entre 1 et 100 mm, par exemple entre 5 et 30 mm, de préférence entre 5 et 15 mm.

3. Machine d'impression selon l'une quelconque des revendications précédentes **caractérisé en ce que** les cellules de la couche structurelle à nid d'abeille ont une taille comprise entre 10 microns et 10 mm, par exemple entre 1 et 8 mm, de préférence entre 2 et 5 mm.

4. Machine d'impression selon l'une quelconque des revendications précédentes **caractérisé en ce que** l'épaisseur des parois des cellules de la couche structurelle à nid d'abeille est comprise entre 0,5 micron et 5 mm, par exemple entre 10 et 200 microns, de préférence entre 30 et 100 microns.

5. Machine d'impression selon l'une quelconque des revendications précédentes **caractérisé en ce que** la couche structurelle à nid d'abeille est à pavage hexagonal régulier.

6. Machine d'impression selon l'une quelconque des revendications précédentes **caractérisé en ce que** la couche structurelle à nid d'abeille est en aluminium.

7. Machine d'impression selon l'une quelconque des revendications précédentes **caractérisé en ce que** le treillis de maintien est présent et est une grille en inox et/ou en fibre céramique.

8. Machine d'impression selon l'une quelconque des revendications précédentes **caractérisé en ce que** le treillis a une épaisseur comprise entre 1 micron et 1 mm, de préférence entre 10 et 500 microns, par exemple entre 25 et 300 microns.

9. Machine d'impression selon l'une quelconque des revendications précédentes **caractérisé en ce que** le treillis a un réseau à maille (par exemple carrée, rectangle, triangulaire, hexagonale ou autre) dont la longueur la plus grande d'un côté de la maille est comprise entre 1 micron et 1 mm, de préférence entre 50 et 500 microns, par exemple entre 75 et 300 microns.

10. Machine d'impression selon l'une quelconque des revendications précédentes **caractérisé en ce que** le treillis a un diamètre de fil compris entre 1 micron et 1 mm, de préférence entre 10 et 200 microns, par exemple entre 25 et 150 microns.

11. Machine d'impression selon l'une quelconque des revendications précédentes **caractérisé en ce que** le treillis est fixé sur la couche structurelle à nid d'abeille.

12. Machine d'impression selon l'une quelconque des revendications précédentes **caractérisé en ce que** la couche structurelle à nid d'abeille et le treillis sont fixés de manière amovible sur la table de maintien.

13. Machine d'impression selon l'une quelconque des revendications précédentes **caractérisé en ce que** le dispositif intègre un système permettant de varier la hauteur et/ou l'orientation et/ou une translations/rotation de la table de maintien, par exemple un système de motorisation et/ou de vérin(s).

14. Machine d'impression selon l'une quelconque des revendications précédentes **caractérisé en ce que** la table de maintien de substrat dans une position immobile par rapport à la table pendant les traitements du substrat est une table aspirante comprenant un ensemble d'aspiration active (zone d'aspiration active) en combinaison avec un ensemble d'aspiration passive (zone d'aspiration passive) qui comprend la couche structurelle à nid d'abeille.

15. Utilisation d'une machine d'impression selon l'une quelconque des revendications précédentes dans un dispositif de transport de substrats dans une machine d'impression comprenant plusieurs postes de traitement dont au moins un poste d'impression et au moins un poste de séchage, le long d'un chemin de transport depuis au moins une zone d'entrée fournissant les substrats imprimables et/ou imprimés, jusqu'à au moins une zone de sortie recevant les substrats traités, le dit dispositif de transport comprenant un convoyeur de substrats permettant de guider et déplacer les substrats au travers des postes de traitement, le dit convoyeur comprenant des chariots qui maintiennent les substrats dans une position immobile et qui se déplacent le long du chemin de transport en transportant les substrats, le dispositif de transport de substrats étant ainsi adapté pour mouvoir chaque chariot le long du chemin de transport et **caractérisé en ce que**
1. le dispositif de transport de substrats comprend un système de motorisation qui permet le déplacement des chariots le long du chemin de transport, et
2. le chariot comprend la table de maintien du substrat dans une position immobile par rapport à la table, le long du chemin de transport pendant le(s) traitement(s) du substrat.

16. Utilisation selon la revendication précédente **caractérisé en ce que** le chemin de transport est une boucle de transport, **en ce que** le convoyeur comprend un rail fixe qui forme la dite boucle de transport et **en ce que** les chariots qui maintiennent les substrats dans une position immobile se déplacent sur le dit rail en transportant les substrats, le dispositif de transport de substrats étant ainsi adapté pour mouvoir chaque chariot sur le rail le long de la boucle de transport et **en ce que**
1. le dispositif de transport de substrats comprend un socle sur lequel au moins une partie du rail est fixée et dont la surface est de préférence plane, et
2. le dispositif de transport de substrats comprend un système de motorisation qui permet le déplacement des chariots sur le rail fixe.

17. Utilisation selon l'une quelconque des revendications 15 et 16 **caractérisé en ce que** le système de motorisation est un système de motorisation linéaire basée sur le principe d'une interaction électromagnétique entre un assemblage de bobines (ensemble primaire) et une voie d'aimants permanents (ensemble secondaire), et **en ce que** l'ensemble primaire moteur de la motorisation linéaire fait partie du chariot mobile et l'ensemble secondaire est constitué d'une voie d'aimants (voie magnétique), la dite voie étant fixée le long du chemin de transport, par exemple sur le rail fixe et/ou faisant partie intégrante du rail fixe et/ou étant fixée sur le socle et/ou faisant partie intégrante du socle et/ou étant fixée sur une structure rigide de maintien du rail et/ou faisant partie intégrante de cette structure rigide.

18. Utilisation selon l'une quelconque des revendications 16 et 17 **caractérisé en ce que** le socle est constitué de marbre et/ou de granite et/ou de granit et/ou de fonte.

19. Utilisation selon l'une quelconque des revendications 16 à 18 **caractérisé en ce que** le système de guidage du chariot sur le rail fixe comprend au moins un couple d'éléments de guidage disposés de part et d'autre du rail (par exemple des roues), chaque couple d'éléments de guidage (par exemple couple de roues) comprenant un mécanisme assurant le guidage du chariot à la fois dans les lignes droites et dans les virages, par exemple une barre de maintien qui relie les deux éléments de guidage entre eux (par exemple les deux roues entre elles), la dite barre de maintien comprenant un axe pivotant relié au chariot permettant d'assurer un guidage optimal du chariot le long du rail et, en particulier le long des virages formés par la boucle de transport.

20. Utilisation selon la revendication précédente **caractérisé en ce que** le système de guidage est un système de guidage en V.

21. Utilisation selon l'une quelconque des revendications 16 à 20 **caractérisé en ce que** le dispositif de transport comprend au moins une glissière de guidage constituée d'un rail et d'un élément de guidage fixé au chariot (de préférence de deux rails disposés de part et d'autre du rail fixe et de deux éléments de guidage), et **en ce que** le rail de la glissière fait partie intégrante du rail fixe et/ou est fixé sur le rail fixe et/ou est fixé sur le socle du rail fixe et/ou fait partie intégrante du socle du rail fixe et/ou est fixé sur la structure porteuse du rail fixe et/ou fait partie intégrante de la structure porteuse du rail fixe, et **en ce que** la longueur totale du rail de la glissière est sélectionnée de manière à couvrir tout l'espace situé en-dessous des postes d'impression de la boucle de transport.

22. Utilisation selon la revendication précédente **caractérisé en ce que** la largeur de l'extrémité initiale (l'entrée dans le sens du déplacement du chariot) et/ou la largeur de l'extrémité finale (la sortie dans le sens du déplacement du chariot) du rail de la glissière est inférieure à la largeur moyenne du dit rail.

23. Utilisation selon l'une quelconque des revendications 15 à 22 **caractérisé en ce que** le dispositif de transport comprend un dispositif d'alimentation en énergie du chariot mobile comprenant un ensemble de rails conducteurs d'électricité le long du chemin de transport et un élément de contact glissant fixé sur le chariot.

24. Utilisation selon l'une quelconque des revendications 15 à 23 **caractérisé en ce que** le dispositif de transport comprend un dispositif de transfert d'informations de/vers le chariot mobile sans contact comprenant un système à câble rayonnant le long du chemin de transport.

25. Utilisation d'une machine d'impression selon l'une quelconque des revendications 1 à 14 comprenant au moins deux postes d'impression différente sans contact en série (de préférence impression numérique à jet d'encre) et au moins un poste de séchage.

26. Utilisation d'une machine d'impression selon la revendication précédente comprenant également un poste de revêtement (par exemple par dépôt d'un revêtement additionnel, par exemple de dorure ou d'autre matière) appliquant/pressant une feuille du dit revêtement sur des zones sélectionnées du substrat (par exemple comportant un dépôt d'adhésif selon un motif prédéterminé) de manière à faire adhérer aux zones sélectionnées la partie désirée de la feuille du dit revêtement.

27. Utilisation d'une machine d'impression selon l'une quelconque des revendications précédentes pour l'électronique imprimée, de préférence pour l'électronique imprimée d'étiquette d'identification par fréquence radio (RFID) avec ou sans puce (aussi appelés tags RFID).

## Patentansprüche

1. Druckmaschine, umfassend eine Vorrichtung zum Halten von Substraten und mehrere Behandlungsstationen, darunter zumindest eine Digitaldruckstation und zumindest eine Trocknungsstation, wobei die Vorrichtung zum Halten von Substraten einen beweglichen Wagen umfasst, der einen Tisch zum Halten von Substrat in einer unbeweglichen Position in Bezug auf den Tisch während der Behandlung(en) des Substrats umfasst, **dadurch gekennzeichnet, dass** der Tisch zum Halten ein Saugtisch ist,
- der eine Wabenstrukturschicht und eine optionale Strukturschicht bestehend aus einem feinmaschigen Geflecht zum Halten der Substrate umfasst, die den Boden zum Halten der Substrate bilden.

2. Druckmaschine nach dem vorhergehenden Anspruch, **dadurch gekennzeichnet, dass** die Wabenstrukturschicht eine Dicke "e" aufweist, die zwischen 1 und 100 mm beträgt, zum Beispiel zwischen 5 und 30 mm, bevorzugt zwischen 5 und 15 mm.

3. Druckmaschine nach einem der vorhergehenden Ansprüche, **dadurch gekennzeichnet, dass** die Zellen der Wabenstrukturschicht eine Größe aufweisen, die zwischen 10 Mikrometer und 10 mm beträgt, zum Beispiel zwischen 1 und 8 mm, bevorzugt zwischen 2 und 5 mm.

4. Druckmaschine nach einem der vorhergehenden Ansprüche, **dadurch gekennzeichnet, dass** die Dicke der Wände der Zellen der Wabenstrukturschicht zwischen 0,5 Mikrometer und 5 mm beträgt, zum Beispiel zwischen 10 und 200 Mikrometer, bevorzugt zwischen 30 und 100 Mikrometer.

5. Druckmaschine nach einem der vorhergehenden Ansprüche, **dadurch gekennzeichnet, dass** die Wabenstrukturschicht ein regelmäßiges hexagonales Pflaster ist.

6. Druckmaschine nach einem der vorhergehenden Ansprüche, **dadurch gekennzeichnet, dass** die Wabenstrukturschicht aus Aluminium ist.

7. Druckmaschine nach einem der vorhergehenden Ansprüche, **dadurch gekennzeichnet, dass** das Geflecht zum Halten vorhanden ist und ein Gitter aus Edelstahl und/oder aus Keramikfaser ist.

8. Druckmaschine nach einem der vorhergehenden Ansprüche, **dadurch gekennzeichnet, dass** das Geflecht eine Dicke aufweist, die zwischen 1 Mikrometer und 1 mm beträgt, bevorzugt zwischen 10 und 500 Mikrometer, zum Beispiel zwischen 25 und 300 Mikrometer.

9. Druckmaschine nach einem der vorhergehenden Ansprüche, **dadurch gekennzeichnet, dass** das Geflecht ein Maschennetz (zum Beispiel quadratisch, rechteckig, dreieckig, hexagonal oder anders) aufweist, dessen größte Länge einer Seite der Masche zwischen 1 Mikrometer und 1 mm beträgt, bevorzugt zwischen 50 und 500 Mikrometer, zum Beispiel zwischen 75 und 300 Mikrometer.

10. Druckmaschine nach einem der vorhergehenden Ansprüche, **dadurch gekennzeichnet, dass** das Geflecht einen Fadendurchmesser aufweist, der zwischen 1 Mikrometer und 1 mm beträgt, bevorzugt zwischen 10 und 200 Mikrometer, zum Beispiel zwischen 25 und 150 Mikrometer.

11. Druckmaschine nach einem der vorhergehenden Ansprüche, **dadurch gekennzeichnet, dass** das Geflecht an der Wabenstrukturschicht befestigt ist.

12. Druckmaschine nach einem der vorhergehenden Ansprüche, **dadurch gekennzeichnet, dass** die Wabenstrukturschicht und das Geflecht auf bewegliche Weise an dem Tisch zum Halten befestigt sind.

13. Druckmaschine nach einem der vorhergehenden Ansprüche, **dadurch gekennzeichnet, dass** die Vorrichtung ein System integriert, das ermöglicht, die Höhe und/oder die Ausrichtung und/oder eine Translation/Rotation des Tisches zum Halten zu variieren, zum Beispiel ein Antriebs- und/oder Zylindersystem.

14. Druckmaschine nach einem der vorhergehenden Ansprüche, **dadurch gekennzeichnet, dass** der Tisch zum Halten von Substrat in einer unbeweglichen Position in Bezug auf den Tisch während der Behandlungen des Substrats ein Saugtisch ist, der eine Einheit aktiver Ansaugung (Zone mit aktiver Ansaugung) in Kombination mit einer Einheit passiver Ansaugung (Zone mit passiver Ansaugung) umfasst, welche die Wabenstrukturschicht umfasst.

15. Verwendung einer Druckmaschine nach einem der vorhergehenden Ansprüche in einer Vorrichtung zum Zuführen von Substraten in einer Druckmaschine, die mehrere Behandlungsstationen umfasst, darunter zumindest eine Druckstation und zumindest eine Trocknungsstation, entlang eines Zuführungsweges von zumindest einer Eintrittszone, welche die bedruckbaren und/oder bedruckten Substrate liefert, bis zu zumindest einer Austrittszone, welche die behandelten Substrate empfängt, wobei die Vorrichtung zum Zuführen einen Substratförderer umfasst, der ermöglicht, die Substrate durch die Behandlungsstationen zu führen und zu verschieben, wobei der Förderer Wagen umfasst, welche die Substrate in einer unbeweglichen Position halten und die sich beim Zuführen der Substrate entlang des Zuführungsweges verschieben, wobei die Zuführungsvorrichtung somit ausgelegt ist, um jeden Wagen entlang des Zuführungsweges zu bewegen und **dadurch gekennzeichnet, dass**
1. die Vorrichtung zum Zuführen von Substraten ein Antriebssystem umfasst, das die Verschiebung der Wagen entlang des Zuführungsweges ermöglicht, und
2. der Wagen den Tisch zum Halten des Substrats in einer unbeweglichen Position in Bezug auf den Tisch entlang des Zuführungsweges während der Behandlung(en) des Substrats umfasst.

16. Verwendung nach dem vorhergehenden Anspruch, **dadurch gekennzeichnet, dass** der Zuführungsweg eine Zuführungsschleife ist, und dass der Förderer eine feste Schiene umfasst, welche die Zuführungsschleife bildet, und dass die Wagen, welche die Substrate in einer unbeweglichen Position halten, sich auf der Schiene beim Zuführen der Substrate verschieben, wobei die Vorrichtung zum Zuführen von Substraten somit ausgelegt ist, um jeden Wagen auf der Schiene entlang der Zuführungsschleife zu bewegen und **dadurch gekennzeichnet, dass**
1. die Vorrichtung zum Zuführen von Substraten einen Sockel umfasst, auf dem zumindest ein Teil der Schiene befestigt ist und dessen Oberfläche bevorzugt eben ist, und
2. die Vorrichtung zum Zuführen von Substraten ein Antriebssystem umfasst, das die Verschiebung der Wagen auf der festen Schiene ermöglicht.

17. Verwendung nach einem der Ansprüche 15 und 16, **dadurch gekennzeichnet, dass** das Antriebssystem ein lineares Antriebssystem ist, das auf dem Grundsatz einer elektromagnetischen Interaktion zwischen einer Spulenbaugruppe (primären Baugruppe) und einer Permanentmagnetspur (sekundären Baugruppe) basiert, und dass die primäre Motorbaugruppe des linearen Antriebs Teil des beweglichen Wagens ist und die sekundäre Baugruppe aus einer Magnetspur (magnetischen Spur) besteht, wobei die Spur entlang des Zuführungsweges befestigt ist, zum Beispiel auf der festen Schiene und/oder einstückig mit der festen Schiene ist und/oder an dem Sockel befestigt ist und/oder einstückig mit dem Sockel ist und/oder an einer starren Haltestruktur der Schiene befestigt ist und/oder einstückig mit dieser starren Struktur ist.

18. Verwendung nach einem der Ansprüche 16 und 17, **dadurch gekennzeichnet, dass** der Sockel aus Marmor und/oder aus Granit und/oder aus Granit und/oder aus Gusseisen besteht.

19. Verwendung nach einem der Ansprüche 16 bis 18, **dadurch gekennzeichnet, dass** das System zum Führen des Wagens auf der festen Schiene zumindest ein Paar Führungselemente umfasst, die beiderseits der Schiene angeordnet sind (zum Beispiel Räder), wobei jedes Paar Führungselemente (zum Beispiel Räderpaar) einen Mechanismus umfasst, der die Führung des Wagens gleichzeitig in geraden Linien und in Kurven sicherstellt, zum Beispiel eine Haltestange, welche die zwei Führungselemente miteinander verbindet (zum Beispiel die zwei Räder miteinander), wobei die Haltestange eine Schwenkachse umfasst, die mit dem Wagen verbunden ist, die ermöglicht, eine optimale Führung des Wagens entlang der Schiene und insbesondere entlang der Kurven sicherzustellen, die durch die Zuführungsschleife gebildet werden.

20. Verwendung nach dem vorhergehenden Anspruch, **dadurch gekennzeichnet, dass** das Führungssystem ein V-Führungssystem ist.

21. Verwendung nach einem der Ansprüche 16 bis 20, **dadurch gekennzeichnet, dass** die Zuführungsvorrichtung zumindest eine Zuführungsgleitschiene umfasst, die aus einer Schiene und einem Führungselement besteht, das an dem Wagen befestigt ist (bevorzugt aus zwei Schienen, die beiderseits der festen Schiene angeordnet sind, und aus zwei Führungselementen), und dass die Zuführungsgleitschiene einstückig mit der festen Schiene ist und/oder an der festen Schiene befestigt ist und/oder an dem Sockel der festen Schiene befestigt ist und/oder einstückig mit dem Sockel der festen Schiene ist und/oder an der Trägerstruktur der festen Schiene befestigt ist und/oder einstückig mit der Trägerstruktur der festen Schiene ist, und dass die Gesamtlänge der Zuführungsgleitschiene ausgewählt ist, um den gesamten Raum abzudecken, der sich unter den Druckstationen der Zuführungsschleife befindet.

22. Verwendung nach dem vorhergehenden Anspruch, **dadurch gekennzeichnet, dass** die Breite des anfänglichen Endes (dem Eintritt in der Richtung der Verschiebung des Wagens) und/oder die Breite des finalen Endes (dem Austritt in der Richtung der Verschiebung des Wagens) der Zuführungsgleitschiene kleiner als die mittlere Breite der Schiene ist.

23. Verwendung nach einem der Ansprüche 15 bis 22, **dadurch gekennzeichnet, dass** die Zuführungsvorrichtung eine Energieversorgungsvorrichtung des beweglichen Wagens umfasst, die eine Schienenbaugruppe zur Elektrizitätsleitung entlang des Zuführungsweges und ein Gleitkontaktelement umfasst, das an dem Wagen befestigt ist.

24. Verwendung nach einem der Ansprüche 15 bis 23, **dadurch gekennzeichnet, dass** die Zuführungsvorrichtung eine Vorrichtung zum digitalen Übertragen von Informationen von/zu dem beweglichen Wagen umfasst, die ein Strahlkabelsystem entlang des Zuführungsweges umfasst.

25. Verwendung einer Druckmaschine nach einem der Ansprüche 1 bis 14, die zumindest zwei verschiedene Digitaldruckstationen in Reihe (bevorzugt Tintenstrahldigitaldruck) und zumindest eine Trocknungsstation umfasst.

26. Verwendung einer Druckmaschine nach dem vorhergehenden Anspruch, die auch eine Beschichtungsstation (zum Beispiel durch Abscheiden einer zusätzlichen Beschichtung, zum Beispiel aus Vergoldung oder einem anderen Material) umfasst, wobei eine Lage der Beschichtung auf ausgewählte Zonen des Substrats (zum Beispiel eine Klebstoffablagerung in einem vorbestimmten Motiv beinhaltend) aufgetragen/gedrückt wird, sodass der gewünschte Teil der Lage der Beschichtung an den ausgewählten Zonen haftet.

27. Verwendung einer Druckmaschine nach einem der vorhergehenden Ansprüche für bedruckte Elektronik, bevorzugt für bedruckte Elektronik mit einem Etikett zur Identifizierung mit Hilfe elektromagnetischer Wellen (RFID) mit oder ohne Chip (auch als RFID-Tag bezeichnet).

## Claims

1. A printing machine comprising a substrate holding device and several processing stations including at least one contactless printing station and at least one drying station, wherein said substrate holding device comprises a movable carriage comprising a substrate holding table in a stationary position relative to the table during substrate processing(s), **characterised in that** the holding table is a suction table
- which comprises a structural honeycomb layer and an optional structural layer consisting of a mesh for holding the fine-mesh substrate which form the substrate-holding bed.

2. The printing machine according to the preceding claim, **characterised in that** the structural honeycomb layer has a thickness "t" between 1 and 100 mm, e.g., between 5 and 30 mm, preferably between 5 and 15 mm.

3. The printing machine according to any of the preceding claims, **characterised in that** the cells of the structural honeycomb layer have a size between 10 µ and 10 mm, e.g., between 1 and 8 mm, preferably between 2 and 5 mm.

4. The printing machine according to any of the preceding claims, **characterised in that** the thickness of the cell walls of the structural honeycomb layer is between 0.5 µ and 5 mm, e.g., between 10 and 200 µ, preferably between 30 and 100 µ.

5. The printing machine according to any of the preceding claims, **characterised in that** the structural honeycomb layer has a regular hexagonal pattern.

6. The printing machine according to any of the preceding claims, **characterised in that** the structural honeycomb layer is made of aluminium.

7. The printing machine according to any of the preceding claims, **characterised in that** the support mesh is present and is a stainless steel and/or ceramic fibre mesh.

8. The printing machine according to any of the preceding claims, **characterised in that** the mesh has a thickness of between 1 µ and 1 mm, preferably between 10 and 500 µ, e.g., between 25 and 300 µ.

9. The printing machine according to any of the preceding claims, **characterised in that** the mesh has a mesh network (e.g., square, rectangular, triangular, hexagonal, or the like) of which the longest length of one side of the mesh is between 1 µ and 1 mm, preferably between 50 and 500 µ, e.g., between 75 and 300 µ.

10. The printing machine according to any of the preceding claims, **characterised in that** the mesh has a wire diameter between 1 µ and 1 mm, preferably between 10 and 200 µ, e.g., between 25 and 150 µ.

11. The printing machine according to any of the preceding claims, **characterised in that** the mesh is attached to the structural honeycomb layer.

12. The printing machine according to any of the preceding claims, **characterised in that** the structural honeycomb layer and the mesh are removably attached to the holding table.

13. The printing machine according to any of the preceding claims, **characterised in that** the device incorporates a system for varying the height and/or orientation and/or translation/rotation of the holding table, e.g., a drive and/or cylinder system.

14. The printing machine according to any of the preceding claims, **characterised in that** the substrate holding table, while in a stationary position relative to the table during substrate processing, is a suction table comprising an active suction assembly (active suction area) in combination with a passive suction assembly (passive suction area) which comprises the structural honeycomb layer.

15. Use of a printing machine according to any of the preceding claims in a substrate transport device in a printing machine comprising several processing stations, including at least one printing station and at least one drying station, along a transport path from at least one entry area providing printable and/or printed substrates, to at least one exit area receiving the processed substrates, wherein said transport device comprises a substrate conveyor for guiding and moving the substrates through the processing stations, said conveyor comprising carriages which hold the substrates in a stationary position and which move along the transport path carrying the substrates, the substrate transport device thus being adapted to move each carriage along the transport path and **characterised in that**
1. the substrate transport device comprises a drive system for moving the carriages along the transport path, and
2. the carriage comprises the substrate holding table in a stationary position relative to the table along the transport path during substrate processing.

16. The use according to the preceding claim, **characterised in that** the transport path is a transport loop, **in that** the conveyor comprises a fixed rail which forms said transport loop, and **in that** the carriages which hold the substrates in a stationary position move on said rail while transporting the substrates, whereby the substrate transport device is adapted to move each carriage on the rail along the transport loop, and **in that**
1. the substrate transport device comprises a base to which at least part of the rail is attached and the surface of which is preferably plane, and
2. the substrate transport device comprises a drive system for moving the carriages on the fixed rail.

17. The use according to any of claims 15 and 16, **characterised in that** the drive system is a linear drive system based on the principle of electromagnetic interaction between a coil assembly (primary assembly) and a permanent magnet track (secondary assembly), and **in that** the primary motor assembly of the linear drive is part of the mobile carriage, and the secondary assembly consists of a track of magnets (magnetic track), wherein said track is attached along the transport path, e.g., on the fixed rail and/or being an integral part of the fixed rail and/or being attached to the base and/or being an integral part of the base and/or being attached to a rigid structure for holding the rail and/or being an integral part of this rigid structure.

18. The use of according to any of claims 16 and 17, **characterised in that** the base consists of marble and/or granite and/or cast iron.

19. The use according to any of claims 16 to 18, **characterised in that** the system for guiding the carriage on the fixed rail comprises at least one pair of guiding elements arranged on either side of the rail (e.g., wheels), wherein each pair of guiding elements (e.g., pair of wheels) comprises a mechanism for guiding the carriage both in straight lines and in curves, e.g., a retaining bar which connects the two guiding elements together (e.g., the two wheels together), said retaining bar comprising a pivoting axis connected to the carriage to ensure optimal guidance of the carriage along the rail and, in particular, along the curves formed by the transport loop.

20. The use according to the preceding claim, **characterised in that** the guide system is a V-guide system.

21. The use according to any of claims 16 to 20, **characterised in that** the transport device comprises at least one guideway consisting of a rail and a guide element attached to the carriage (preferably two rails arranged on either side of the fixed rail, and two guide elements), and **in that** the rail of the guideway is an integral part of the fixed rail and/or is attached to the fixed rail and/or is attached to the base of the fixed rail and/or is an integral part of the base of the fixed rail and/or is attached to the supporting structure of the fixed rail and/or is an integral part of the supporting structure of the fixed rail, and **in that** the total length of the rail of the slide is selected such that it covers all of the space located below the printing stations of the transport loop.

22. The use according to the preceding claim, **characterised in that** the width of the initial end (the entry in the direction of movement of the carriage) and/or the width of the final end (the exit in the direction of movement of the carriage) of the rail of the slide is less than the average width of said rail.

23. The use of according to any of claims 15 to 22, **characterised in that** the transport device comprises a power supply device for the mobile carriage comprising a set of electrically conductive rails along the transport path and a sliding contact element attached to the carriage.

24. The use according to any of claims 15 to 23, **characterised in that** the transport device comprises a device for transferring information to/from the mobile contactless carriage comprising a cable system radiating along the transport path.

25. The use of a printing machine according to any of claims 1 to 14, comprising at least two different contactless printing stations in series (preferably digital inkjet printing) and at least one drying station.

26. The use of a printing machine according to the preceding claim further comprising a coating station (e.g., by depositing an additional coating, e.g., gold plate or other material) applying/pressing a sheet of said coating onto selected areas of the substrate (e.g., having an adhesive deposited thereon in a predetermined pattern) such that the desired portion of the sheet of said coating is adhered to the selected areas.

27. The use of a printing machine according to any of the preceding claims for printed electronics, preferably printed electronics of radio frequency identification (RFID) tags with or without chips (also referred to as RFID tags).
